# EUROPEAN PATENT APPLICATION

(11) **EP 0 982 360 A1**
(43) Date of publication of application: **01.03.2000**
(21) Application number: 98919520.1
(22) Date of filing: 30.04.1998
(51) Int. Cl.: C08L 21/00, C08L 101/00, C08K 3/00, H05K 9/00, H01B 1/24, C08K 3/02

(54) **ELECTROMAGNETIC WAVE SHIELDING MATERIAL, AND ELECTROMAGNETIC WAVE SHIELDING SHEET, ELECTRIC WIRE/CABLE AND CABLE COVER EACH MADE OF THE MATERIAL**

(30) Priority: 30.04.1997 JP 12809697; 02.12.1997 JP 34855897
(71) Applicant: Tuchiyagomu Co., Ltd., Kumamoto 861-3106 (JP)
(72) Inventor: KURATA, Yuhei, Kamimashiki-gun Kumamoto 861-3106 (JP); FURUSHIMA, Hidetoshi, Kamimashiki-gun Kumamoto 861-3106 (JP)
(74) Representative: Klunker . Schmitt-Nilson . Hirsch
(86) International application number: JP9802041
(87) International publication number: WO9849228

(57) **Abstract**

An electromagnetic wave-shielding material is obtained by adding conductive filler to a rubber material or a plastic material and by adding sulfur in an amount of from 4 to 16 weight parts relative to 100 weight parts of the rubber or plastic material. The electromagnetic wave-shielding material can block off the electromagnetic wave in the high frequency band. A sheet and a cable cover formed of the electromagnetic wave-shielding material and an electric wire or cable, in which a core wire is covered with the electromagnetic wave-shielding material have a good electromagnetic wave-shielding property, a suitable flexibility and an excellent handling property. They can easily be manufactured in low cost and space saving can be achieved.

## Description

The present invention relates to an electromagnetic wave-shielding material for blocking off an electromagnetic wave, and especially to an electromagnetic wave-shielding material mainly formed of rubber or plastic material, and an electromagnetic wave-shielding sheet made of the above-mentioned electromagnetic wave-shielding material, an electric wire or cable having an outer cover made of the above-mentioned electromagnetic wave-shielding material, and a cable cover made of the above-mentioned electromagnetic wave-shielding material.

### Background Art

Recently, an electronic instrument is composed of digital circuits, and parts of the electronic instrument include a large number of integral circuits so as to be able to operate through ringing micro current, thus leading to power saving. Due to this fact, there easily occurs the so-called "EMI (Electromagnetic Interference)", i.e., the phenomenon that the ringing current for the electronic instrument is disturbed by electromagnetic wave generated by the instrument itself or interfering electromagnetic wave from other electronic instrument. Electromagnetic wave (noise) causing the EMI includes conductive noise, which is propagated through circuits and wire of the electronic instrument and radiant noise, which is propagated in the air. In general, the conductive noise can be removed by putting a filter or the like in the circuit. With respect to the radiant noise, it is however necessary to carry out electromagnetic wave-shield for covering an electric instrument or the like to be shielded with conductive material so as to prevent permeation of electromagnetic wave therethrough.

As the conventional electromagnetic wave-shielding method, there is known a method using conductive composite plastic forming material, a conductive surface-treating method, a method using metallic material, or the like.

The above-mentioned method using the conductive composite plastic forming material comprises a step of integrally forming a casing body having a prescribed shape with the use of forming material, which is obtained by adding conductive filler to ABS (acrylonitrile butadiene styrene) resin, polypropylene resin, nylon resin, or the like. The conductive filler may comprise conductive carbon, carbon fiber, metallic flake, metallic fiber and the like.

The above-mentioned conductive surface-treating method comprises a step of covering a front or back surface of a casing body for receiving an electronic instrument or the like to be subjected to the EMI, with a conductive film. The conductive film may be formed by means of a zinc thermal spraying method, an applying method of conductive composition, with which powder of nickel, carbon and the like is mixed, a vacuum evaporation method of aluminum, or the like.

The above-mentioned metallic material comprises a metallic foil, a laminated sheet of the metallic foil and a plastic film, or the like. Such metallic material is used mainly as a partial shielding material for parts or connected portions, so as to cover a noise-generating portion.

A cable used as a wire in an electronic instrument or used for connecting an electronic instrument with the other electronic instrument has often been exposed, on the other hand, to the above-mentioned conductive noise as well as the radiant noise from the outside of the electronic instrument. Electromagnetic wave, i.e., the radiant noise has been generated from the cable or wire itself by passing an electric current therethrough. In such a cable, the conductive noise generated from the radiant noise and the conductive noise directly propagated from the instrument have conventionally been removed by a filter such as a ferrite core or the like, and the influence of an external electromagnetic wave and the generation of the electromagnetic wave from the cable itself have conventionally been inhibited by using a shielded cable.

Electric wires having on the periphery of its conductive body neither metallic foil nor metallic net as a shield may not have remarkable influence of the external electromagnetic wave. The electromagnetic wave has however been generated from the electric wire itself and has been radiated.

The conventional electromagnetic wave-shielding method has been carried out in a manner mentioned above. Accordingly, in case that the conductive composite plastic forming material and the metallic material was used, it has technically been hard to prepare a shield having the sufficient dimensions to shield the entire building or room, and production cost has been increased, thus causing problems. The conventional conductive material had a problem that a sufficient sound insulation property and a sufficient impact absorption property could not be obtained.

With respect to objects, which might be subject to vibration, such as automobiles, vehicles, airplanes and the like, it has been hard to carry out the electromagnetic-shield under the satisfied conditions of vibration controlling or proof property with the use of the conventional conductive material.

In addition, the conventional electromagnetic shield of the cable has problems that the filter of the ferrite core or the like can be used only as a partial shield, thus leading to an insufficient shielding property, and an extra space for providing the filter is required, with the result that it is hard to apply such a conventional electromagnetic shield to a cable for wiring in the inside of the electronic instrument, which is in general required to be miniaturized.

With respect to the shielded cable, the metallic net or the metallic foil is required to be provided in the cable, and the cable therefore has a complex structure, thus leading to a poor productivity and a high production cost. It is necessary to add not only conductive material but also magnetic material to the shielding material in order to carry out the electromagnetic shield, which can block off influences of both of the electric field and the magnetic field, and the cable therefore has a more complex structure, thus leading to a higher production cost.

Conceivable is a method of covering the entire cable or electric wire with the above-mentioned conductive composite plastic material or metallic material so as to ensure the electromagnetic wave-shield. However, it is not easy to manufacture a formed body corresponding to the cable or electric wire with the use of the conductive composite plastic material or metallic material, thus leading to a high production cost. In addition, the thus manufactured body does not have a sufficient flexibility, resulting in difficulty in mounting the body on the cable or electric wire. Especially, it is hard to form the body for the cable or electric wire having a smaller diameter with the use of the above-mentioned material, which body has a prescribed smaller diameter and a sufficient flexibility, provides a satisfied condition of insulating property against the core wire and permits to maintain space saving.

With respect to the electric wire such as a high-voltage cable, electromagnetic wave is generated from the electric wire itself. Such an electric wire has on the periphery of its conductive body neither metallic foil nor metallic net as a shield, and the electromagnetic wave-shield is not carried out at all. There is an anxious matter about influence of the generated electromagnetic wave on environment.

Objects of the present invention, which was made in order to solve the above-described problems, are to provide an electromagnetic wave-shielding material, which is excellent in sound insulation property, impact absorption property and vibration controlling property, and can easily be manufactured for a large-sized object to be shielded at a low cost; an electromagnetic wave-shielding sheet made of the above-mentioned shielding material; an electric wire or cable having an easy handling property, in which an outer cover made of the above-mentioned shielding material is integrally formed with the core wire without extra space so as to permit an easy manufacture at a low cost; and a cable cover made of the above-mentioned shielding material.

### Disclosure of Invention

In an electromagnetic wave-shielding material of the present invention, conductive filler is added to a rubber material so as to impart conductivity to the rubber material, and sulfur is added to the rubber material having the conductivity in an amount of from 4 to 16 weight parts relative to 100 weight parts of the rubber material. In the present invention, it is possible to block off the electromagnetic wave especially in a high frequency band by adding sulfur to the rubber material to which the conductive filler is added so as to impart the conductivity to the rubber material, in an amount of from 4 to 16 weight parts relative to 100 weight parts of the rubber material. The electromagnetic wave-shielding material is therefore excellent in sound insulation property, impact absorption property and vibration controlling property, and can easily be manufactured for a large-sized object to be shielded at a low cost.

In the electromagnetic wave-shielding material of the present invention, the conductive filler comprises conductive carbon, as the occasion demands. It is possible to impart stably and uniformly the conductivity to the rubber material by using the conductive carbon as conductive filler in the present invention.

In the electromagnetic wave-shielding material of the present invention, zinc white is added to the rubber material, as the occasion demands. It is possible to impart uniformly and securely the conductivity to the rubber material by adding the zinc white as curing assistant to the rubber material in the present invention. The electromagnetic wave-shielding material is therefore excellent in sound insulation property, impact absorption property and vibration controlling property, and can easily be manufactured for a large-sized object to be shielded at a low cost.

In the electromagnetic wave-shielding material of the present invention, conductive carbon of from 35 to 65 weight parts and zinc white of from 3 to 30 weight parts both relative to 100 weight parts of the rubber material are added to the rubber material so as to impart the conductivity to the same, as the occasion demands. It is possible to impart stably and uniformly the conductivity to the rubber material and improve the electromagnetic wave-shielding property in a high frequency band by adding the conductive carbon and the zinc white to the rubber material in prescribed amounts in the present invention.

In the electromagnetic wave-shielding material of the present invention, a net member formed of metal is held between members made of the rubber material or the rubber material, to which any one of the additives is added, as the occasion demands. Since the net member formed of metal is held between the members of the rubber material to which the conductivity is imparted in the present invention, the shielding material has the electromagnetic wave-shielding property equal to that of the metallic plate for forming the net member over the entire frequency band from low frequency to high frequency.

In the electromagnetic wave-shielding material of the present invention, metallic short fiber is added to the rubber material in an amount of from 20 to 40 weight parts relative to 100 weight parts of the rubber material, as the occasion demands. Since the metallic short fiber is added to the rubber material in a prescribed amount in the present invention, the shielding material has the electromagnetic wave-shielding property analogous to that of the metallic plate for forming the net member over the entire frequency band from low frequency to high frequency.

In the electromagnetic wave-shielding material of the present invention, carbon fiber is added to the rubber material in an amount of from 10 to 50 weight parts relative to 100 weight parts of the rubber material so as to impart the conductivity to the same, as the occasion demands. Since the carbon fiber is added to the rubber material in an amount of from 10 to 50 weight parts so as to impart the conductivity to the same in the present invention, it is possible to impart securely the conductivity to the rubber material, and the shielding material has the electromagnetic wave-shielding property equal to that of the metallic plate for forming the net member over the entire frequency band from low frequency to high frequency. Such a shielding material is also excellent in sound insulation property, impact absorption property and vibration controlling property, and can easily be manufactured for a large-sized object to be shielded at a low cost.

In the electromagnetic wave-shielding material of the present invention, conductive carbon is added to plastic material in an amount of from 35 to 65 weight parts relative to 100 weight parts of the plastic material, and carbon fiber is added to the plastic material in an amount of from 10 to 40 weight parts relative to 100 weight parts of the plastic material. The conductive carbon and the carbon fiber are added to the plastic material in the respective prescribed amounts so as to impart a stable and uniform conductivity to the plastic material in this manner in the present invention. When the shielding material is used as a shield for covering the object to be shielded, such as an electronic instrument, there can be obtained the electromagnetic wave-shielding property against the electromagnetic wave in the wide frequency band from low frequency to high frequency, which property is equal to that of an electromagnetic wave-shield formed of a metallic plate. Such a shield can block off the electromagnetic wave especially in the high frequency band, which causes the occurrence of the EMI, is also excellent in sound insulation property, impact absorption property and vibration controlling property, can easily be manufactured at a low cost and can be applied to a large-sized object to be shielded without causing any problem.

In the electromagnetic wave-shielding material of the present invention, sulfur is added to the plastic material in an amount of from 4 to 16 weight parts relative to 100 weight parts of the plastic material, as the occasion demands. Since a prescribed amount of the sulfur is added to the plastic material, to which the conductivity is imparted by the addition of the conductive carbon in the present invention, it is possible to impart more stably and uniformly the conductivity to the plastic material and to further improve the electromagnetic wave-shielding property in the high frequency band.

In the electromagnetic wave-shielding material of the present invention, zinc white is added to the plastic material in an amount of from 3 to 30 weight parts relative to 100 weight parts of the plastic material, as the occasion demands. Since a prescribed amount of the zinc white is added to the plastic material in the present invention, it is possible to impart more uniformly and surely the conductivity to the plastic material and to easily manufacture the shield at a low cost, which is excellent in sound insulation property, impact absorption property and vibration controlling property.

In the electromagnetic wave-shielding sheet of the present invention, the above-mentioned electromagnetic wave-shielding material is formed into a sheet body, and the sheet body has a plurality of holes formed thereon so as to be spaced apart by a prescribed distance from each other, which pass through the sheet body and has a prescribed shape. A plurality of holes are formed so as to be spaced apart by the prescribed distance on the electromagnetic wave-shielding material formed into the sheet body in the present invention in this manner. When the shielding sheet is used as a shield for covering an object to be shielded such as an electronic instrument, it is possible to ensure the shielding property against the electromagnetic wave, and achieve ventilation through the shielding sheet so as to permit diffusion of heat from the inside thereof. As a result, any specific mechanism or device for diffusion of heat is not required and the formation of the holes causes the weight of the shielding sheet to be decreased, thus reducing the costs of the whole apparatus.

In the electromagnetic wave-shielding sheet of the present invention, the sheet body is formed into a rectangular shape, in which a first connecting portion having a prescribed shape is formed so as to extend peripherally over adjacent two sides of a periphery thereof, and a second connecting portion having a prescribed shape is formed so as to extend peripherally over remaining adjacent two sides of the periphery, the second connecting portion being connectable integrally with a first connecting portion of another sheet body having the same structure as the sheet body, as the occasion demands. The sheet body has on its periphery the first and second connecting portions so that the first connecting portion can be connected with a second connecting portion of the other sheet body in the present invention. When the plurality of electromagnetic wave-shielding sheets are arranged in rows, it is therefore possible to make arrangement of the shielding sheets without forming a gap between two adjacent sheets, with the result that the maximum shielding property can be exhibited without deteriorating the shielding property at the connected portions and a uniform shielding effect can be obtained over the wide range by means of a plurality of electromagnetic wave-shielding sheets. If the electromagnetic wave-shielding material has polarity, it is possible to make arrangement of the shielding sheets so as to maintain a proper polarity without making an improper arrangement thereof by connecting the first connecting portion of the shielding sheet with the second connecting portion of the other shielding sheet in an appropriate manner, thus providing surely the shielding effect and permitting easy and rapid execution of arrangement.

In the electromagnetic wave-shielding sheet of the present invention, the sheet body has front and back surfaces, which are different in color from each other, as the occasion demands. The front and back surfaces of the sheet body has different colors from each other so as to facilitate to make distinction between the front and back surfaces thereof in this manner in the present invention. Even when the shielding property at the front surface of the sheet body is slightly different from that at the back surface thereof, the shielding sheets can be arranged under a proper condition, thus providing surely the prescribed shielding property.

In the electric wire or cable of the present invention, at least one core wire is covered integrally with the electromagnetic wave-shielding material by means of an extrusion method. Since the core wire is covered with the electromagnetic wave-shielding material having a basic constituent of rubber material or plastic material in the present invention, it is possible to block off the electromagnetic wave, especially the electromagnetic wave in the high frequency band only by an outer cover made of the electromagnetic wave-shielding material. Accordingly, the electric wire or cable of the present invention can achieve space saving and easily be manufactured at a low cost without degrading its flexibility.

In the electric wire or cable of the present invention, fine short fiber or powder of a metallic compound having an electromagnetic wave-absorbing property is added to the rubber material or the plastic material composing the electromagnetic wave-shielding material in an amount of from 50 to 230 weight parts relative to 100 weight parts of the rubber material or the plastic material, as the occasion demands. Since the prescribed amount of the fine short fiber or powder of the metallic compound having the electromagnetic wave-absorbing property is added to the rubber material or the plastic material, there can be exhibited the electromagnetic wave-shielding property, which is effective over the entire frequency band from low frequency to high frequency and analogous to that of the electromagnetic shield made of a plate of metallic compound, and the sufficient flexibility can simultaneously be ensured.

In the electric wire or cable of the present invention, the core wire is covered with the electromagnetic wave-shielding material and an other rubber or plastic material having no conductivity so that the core wire is coated with layers of the electromagnetic wave-shielding material and the other rubber or plastic material, as the occasion demands. The outer cover of the cable has a plural-layer structure of the layer of the electromagnetic wave-shielding material and the layer of the other rubber or plastic material in this manner in the present invention. When the layer of the other rubber or plastic material is arranged as an outermost layer or an innermost layer, the insulating condition of the core wire from the outside can be ensured by the above-mentioned layer of the other rubber or plastic material. There is therefore required no consideration of the specific insulating treatment to be applied to the cable, thus permitting the use of the cable alone even in any situation.

In the electric wire or cable of the present invention, the electromagnetic wave-shielding material covers the core wire so that the electromagnetic wave-shielding material is held between two layers of the other rubber or plastic material, as the occasion demands. The outer cover of the cable has a triple-layer structure in which the layer of the electromagnetic wave-shielding material is held between the two layers of the other rubber or plastic material in this manner in the present invention. As a result, the layer of the electromagnetic wave-shielding material can surely be insulated from the core wire and the outside by means of the outermost and innermost layers of the other rubber material or plastic material. There is therefore required no consideration of the specific insulating treatment to be applied to the cable, thus permitting the use of the cable alone even in any situation. In addition, even when the outermost layer is removed for the purpose of an engineering work or the like, the current flowing through the core wire is prevented from being leaked, thus ensuring safety.

In the electric wire or cable of the present invention, the core wire is covered with a plurality of laminated layers of the electromagnetic wave-shielding material, which are different in polarity from each other, as the occasion demands. The combination of the plurality of layers of the electromagnetic wave-shielding material constitutes a laminated-layer structure in which the layers thereof are arranged so as to be different in polarity from each other in this manner in the present invention. Accordingly, a non-uniform condition of the electromagnetic wave-shielding property due to variation in polarity upon manufacturing the electromagnetic wave-shielding material can be improved and the influence thereof can also be minimized. As a result, it is possible to surely exhibit the electromagnetic wave-shielding property and provide a remarkable damping effect against the electromagnetic wave in comparison with a single layer of the electromagnetic wave-shielding material having the same thickness.

In the cable cover of the present invention, the electromagnetic wave-shielding material, which is obtained by adding sulfur to the rubber or plastic material, to which the conductivity is imparted by addition of the conductive filler, in an amount of from 4 to 16 weight parts relative to 100 weight parts of the rubber or plastic material, is formed into a tubular shape, with which at least one electric wire or cable is surrounded. The electromagnetic wave-shielding material obtained by the addition of the conductive filer and a prescribed amount of sulfur to the rubber or plastic material is formed into the tubular shape, with which the electric wire or cable is surrounded in this manner in the present invention. It is therefore possible to block off the electromagnetic wave, especially the electromagnetic wave in the high frequency band, which has influence on the electric wire or cable from the outside thereof or is generated from the electric wire or cable to exert influence on the environment.

In the cable cover of the present invention, the electromagnetic wave-shielding material is laminated with at least one layer of rubber or plastic material having no conductivity so as to form a tubular shape, as the occasion demands. The cable cover has a plural-layer structure of the layer of the electromagnetic wave-shielding material is laminated with the layer of the other rubber of plastic material. As a result, it is possible to ensure insulating property between the outside and the inside. There is therefore required no consideration of the specific insulating treatment to be applied to the electric wire or cable, thus permitting the safe use of the cable cover for any kind of the electric wire or cable.

### Brief Description of Drawings

FIG. 1 is a blending table indicating each of the blending examples Nos. 1 to 9 for an electromagnetic wave-shielding material of the first embodiment of the present invention.
FIG. 2(A) is a graph of the electromagnetic wave-shielding property of the blending example No. 1 for the electromagnetic wave-shielding material of the first embodiment of the present invention, FIG. 2(B) is a graph of the electromagnetic wave-shielding property of the blending example No. 2 for the electromagnetic wave-shielding material of the first embodiment of the present invention, and FIG. 2(C) is a graph of the electromagnetic wave-shielding property of the blending example No. 3 for the electromagnetic wave-shielding material of the first embodiment of the present invention.
FIG. 3(A) is a graph of the electromagnetic wave-shielding property of the blending example No. 4 for the electromagnetic wave-shielding material of the first embodiment of the present invention, FIG. 3(B) is a graph of the electromagnetic wave-shielding property of the blending example No. 5 for the electromagnetic wave-shielding material of the first embodiment of the present invention, and FIG. 3(C) is a graph of the electromagnetic wave-shielding property of the blending example No. 6 for the electromagnetic wave-shielding material of the first embodiment of the present invention.
FIG. 4(A) is a graph of the electromagnetic wave-shielding property of the blending example No. 7 for the electromagnetic wave-shielding material of the first embodiment of the present invention, FIG. 4(B) is a graph of the electromagnetic wave-shielding property of the blending example No. 8 for the electromagnetic wave-shielding material of the first embodiment of the present invention, and FIG. 4(C) is a graph of the electromagnetic wave-shielding property of the blending example No. 9 for the electromagnetic wave-shielding material of the first embodiment of the present invention.
FIG. 5 is a blending table indicating each of the blending examples Nos. 10 to 12 for the electromagnetic wave-shielding material of the second embodiment of the present invention.
FIG. 6(A) is a graph of the electromagnetic wave-shielding property of the blending example No. 10 for the electromagnetic wave-shielding material of the second embodiment of the present invention, FIG. 6(B) is a graph of the electromagnetic wave-shielding property of the blending example No. 11 for the electromagnetic wave-shielding material of the second embodiment of the present invention, and FIG. 6(C) is a graph of the electromagnetic wave-shielding property of the blending example No. 12 for the electromagnetic wave-shielding material of the second embodiment of the present invention.
FIG. 7 is a blending table indicating each of the blending examples Nos. 13 to 21 for the electromagnetic wave-shielding material of the third embodiment of the present invention.
FIG. 8(A) is a graph of the electromagnetic wave-shielding property of the blending example No. 13 for the electromagnetic wave-shielding material of the third embodiment of the present invention, FIG. 8(B) is a graph of the electromagnetic wave-shielding property of the blending example No. 14 for the electromagnetic wave-shielding material of the third embodiment of the present invention, and FIG. 8(C) is a graph of the electromagnetic wave-shielding property of the blending example No. 15 for the electromagnetic wave-shielding material of the third embodiment of the present invention.
FIG. 9(A) is a graph of the electromagnetic wave-shielding property of the blending example No. 16 for the electromagnetic wave-shielding material of the third embodiment of the present invention, FIG. 9(B) is a graph of the electromagnetic wave-shielding property of the blending example No. 17 for the electromagnetic wave-shielding material of the third embodiment of the present invention, and FIG. 9(C) is a graph of the electromagnetic wave-shielding property of the blending example No. 18 for the electromagnetic wave-shielding material of the third embodiment of the present invention.
FIG. 10(A) is a graph of the electromagnetic wave-shielding property of the blending example No. 19 for the electromagnetic wave-shielding material of the third embodiment of the present invention, FIG. 10(B) is a graph of the electromagnetic wave-shielding property of the blending example No. 20 for the electromagnetic wave-shielding material of the third embodiment of the present invention, and FIG. 10(C) is a graph of the electromagnetic wave-shielding property of the blending example No. 21 for the electromagnetic wave-shielding material of the third embodiment of the present invention.
FIG. 11 is a blending table indicating each of the blending examples Nos. 22 to 24 for the electromagnetic wave-shielding material of the fourth embodiment of the present invention.

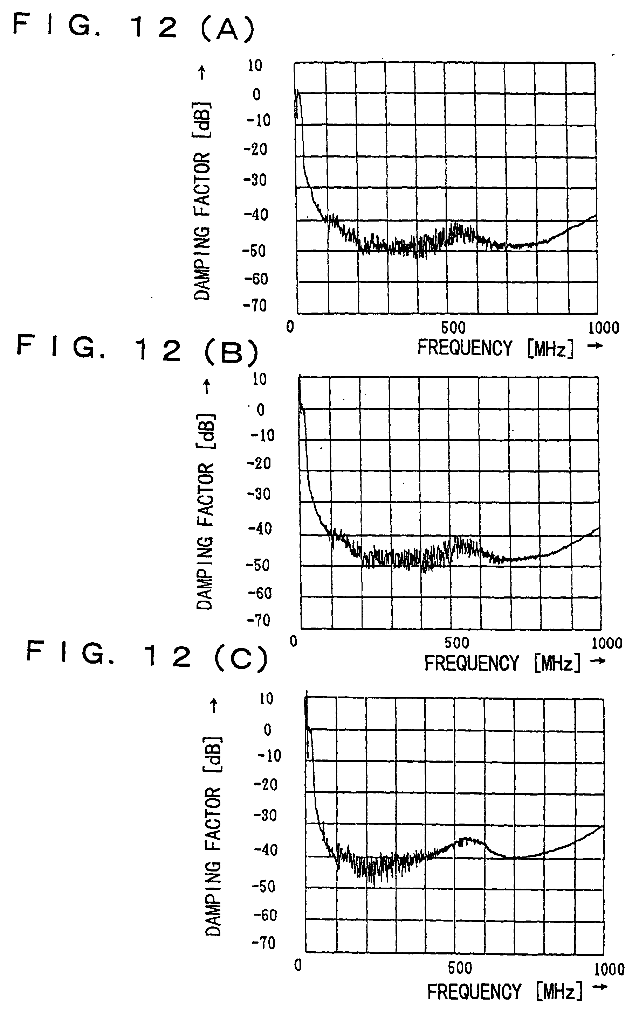

FIG. 12(A) is a graph of the electromagnetic wave-shielding property of the blending example No. 22 for the electromagnetic wave-shielding material of the fourth embodiment of the present invention, FIG. 12(B) is a graph of the electromagnetic wave-shielding property of the blending example No. 23 for the electromagnetic wave-shielding material of the fourth embodiment of the present invention, and FIG. 12(C) is a graph of the electromagnetic wave-shielding property of the blending example No. 24 for the electromagnetic wave-shielding material of the fourth embodiment of the present invention.
FIG. 13 is a blending table indicating each of the blending examples Nos. 25 to 29 for the electromagnetic wave-shielding material of the fifth embodiment of the present invention.
FIG. 14(A) is a comparative graph of the electromagnetic wave-shielding property of each of the blending example Nos. 25 to 28 for the electromagnetic wave-shielding material of the fifth embodiment of the present invention, FIG. 14(B) is a graph of the electromagnetic wave-shielding property of the blending example No. 29 for the electromagnetic wave-shielding material of the fifth embodiment of the present invention, and FIG. 14(C) is a graph of the electromagnetic wave-shielding property of an aluminum plate.
FIG. 15 is a comparative graph of the electromagnetic wave-shielding property of each of the blending example Nos. 30 and 31 for the electromagnetic wave-shielding material of the sixth embodiment of the present invention.
FIG. 16 is a blending table indicating each of the blending examples Nos. 32 to 35 for the electromagnetic wave-shielding material of the seventh embodiment of the present invention.
FIG. 17 is a graph of the electromagnetic wave-shielding property of the blending example No. 32 for the electromagnetic wave-shielding material of the seventh embodiment of the present invention.
FIG. 18 is a graph of the electromagnetic wave-shielding property of the blending example No. 33 for the electromagnetic wave-shielding material of the seventh embodiment of the present invention
FIG. 19 is a graph of the electromagnetic wave-shielding property of the blending example No. 34 for the electromagnetic wave-shielding material of the seventh embodiment of the present invention
FIG. 20 is a graph of the electromagnetic wave-shielding property of the blending example No. 35 for the electromagnetic wave-shielding material of the seventh embodiment of the present invention
FIG. 21(A) is a plan view of an electromagnetic wave-shielding sheet of the eighth embodiment of the present invention, and FIG. 21(B) is a partial cross-sectional view of the electromagnetic wave-shielding sheet of the eighth embodiment of the present invention.
FIG. 22(A) is a descriptive view of the electromagnetic wave-shielding sheets of the eighth embodiment of the present invention, which are arranged side by side, FIG. 22(B) is a cross-sectional view of the connected portions of another electromagnetic wave-shielding sheets of the eighth embodiment of the present invention, and FIG. 22(C) is a cross-sectional view of the connected portions of further another electromagnetic wave-shielding sheets of the eighth embodiment of the present invention.
FIG. 23 is a reference graph of the electromagnetic wave-shielding property of the electromagnetic wave-shielding sheet of the eighth embodiment of the present invention.
FIG. 24 is a composition table indicating the composition example Nos. 36 to 47 for the electromagnetic wave-shielding sheet of the eighth embodiment of the present invention.
FIG. 25 is a graph of the electromagnetic wave-shielding property of the composition example No. 36 for the electromagnetic wave-shielding sheet of the eighth embodiment of the present invention.
FIG. 26 is a graph of the electromagnetic wave-shielding property of the composition example No. 37 for the electromagnetic wave-shielding sheet of the eighth embodiment of the present invention.
FIG. 27 is a graph of the electromagnetic wave-shielding property of the composition example No. 38 for the electromagnetic wave-shielding sheet of the eighth embodiment of the present invention.
FIG. 28 is a graph of the electromagnetic wave-shielding property of the composition example No. 39 for the electromagnetic wave-shielding sheet of the eighth embodiment of the present invention.
FIG. 29 is a graph of the electromagnetic wave-shielding property of the composition example No. 40 for the electromagnetic wave-shielding sheet of the eighth embodiment of the present invention.
FIG. 30 is a graph of the electromagnetic wave-shielding property of the composition example No. 41 for the electromagnetic wave-shielding sheet of the eighth embodiment of the present invention.
FIG. 31 is a graph of the electromagnetic wave-shielding property of the composition example No. 42 for the electromagnetic wave-shielding sheet of the eighth embodiment of the present invention.
FIG. 32 is a graph of the electromagnetic wave-shielding property of the composition example No. 43 for the electromagnetic wave-shielding sheet of the eighth embodiment of the present invention.
FIG. 33 is a graph of the electromagnetic wave-shielding property of the composition example No. 44 for the electromagnetic wave-shielding sheet of the eighth embodiment of the present invention.
FIG. 34 is a graph of the electromagnetic wave-shielding property of the composition example No. 45 for the electromagnetic wave-shielding sheet of the eighth embodiment of the present invention.
FIG. 35 is a graph of the electromagnetic wave-shielding property of the composition example No. 46 for the electromagnetic wave-shielding sheet of the eighth embodiment of the present invention.
FIG. 36 is a graph of the electromagnetic wave-shielding property of the composition example No. 47 for the electromagnetic wave-shielding sheet of the eighth embodiment of the present invention.
FIG. 37(A) is a schematic construction perspective view of the composition example No. 48 of a cable of the ninth embodiment of the present invention, and FIG. 37(B) is a cross-sectional view of the composition example No. 48 of the cable of the ninth embodiment of the present invention.
FIG. 38(A) is a cross-sectional view of the composition example No. 49 of the cable of the ninth embodiment of the present invention, and FIG. 38(B) is a cross-sectional view of the composition example No. 50 of the cable of the ninth embodiment of the present invention.
FIG. 39(A) is a cross-sectional view of the composition example No. 51 of the cable of the ninth embodiment of the present invention, and FIG. 39(B) is a cross-sectional view of the composition example No. 52 of the cable of the ninth embodiment of the present invention.
FIG. 40 is a blending table for the outer cover of the cable of the ninth embodiment of the present invention.
FIG. 41 is a construction descriptive view of the outer cover of the composition example Nos. 48 to 53 of the cable of the ninth embodiment of the present invention.
FIG. 42 is a graph of the electromagnetic wave-shielding property of the composition example No. 48 of the cable of the ninth embodiment of the present invention.
FIG. 43 is a graph of the electromagnetic wave-shielding property of the composition example No. 49 of the cable of the ninth embodiment of the present invention.
FIG. 44 is a graph of the electromagnetic wave-shielding property of the composition example No. 50 of the cable of the ninth embodiment of the present invention.
FIG. 45 is a graph of the electromagnetic wave-shielding property of the composition example No. 51 of the cable of the ninth embodiment of the present invention.
FIG. 46 is a graph of the electromagnetic wave-shielding property of the composition example No. 52 of the cable of the ninth embodiment of the present invention.
FIG. 47 is a graph of the electromagnetic wave-shielding property of the composition example No. 53 of the cable of the ninth embodiment of the present invention.
FIG. 48 is a schematic construction descriptive view of a cable cover of the tenth embodiment of the present invention.

### Best Mode for Carrying out the Invention

### [First Embodiment]

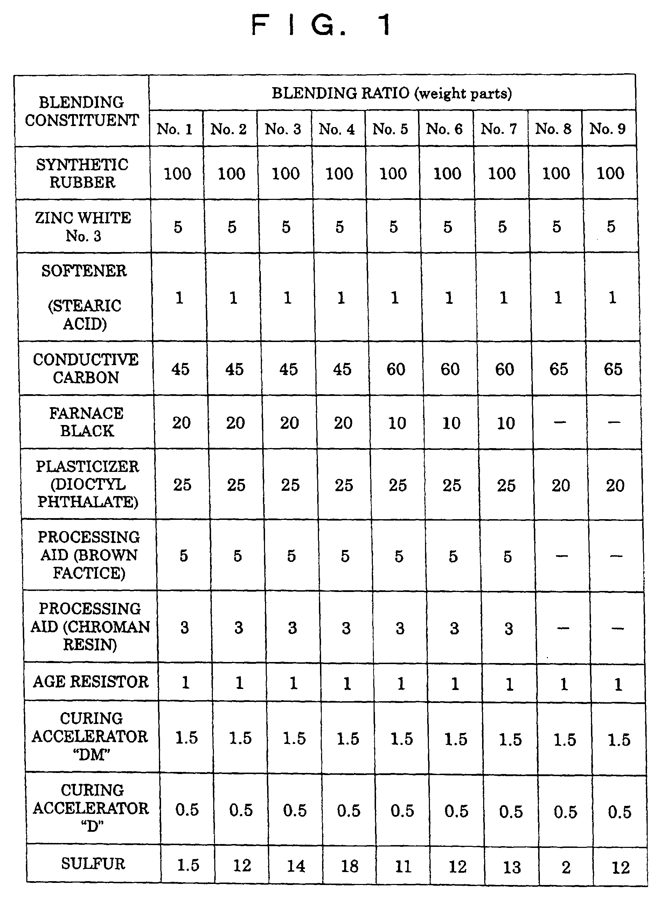

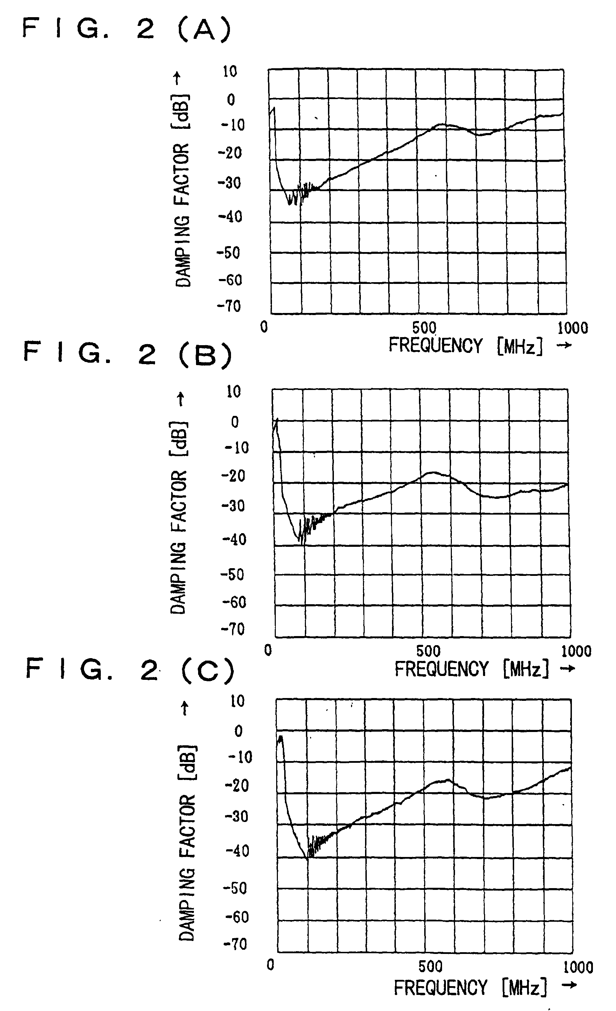

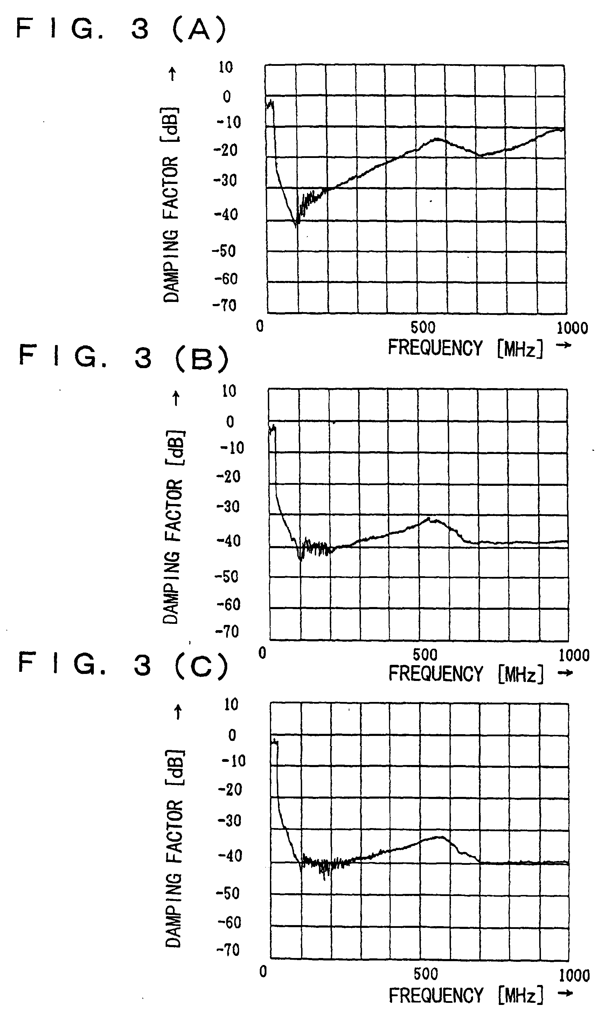

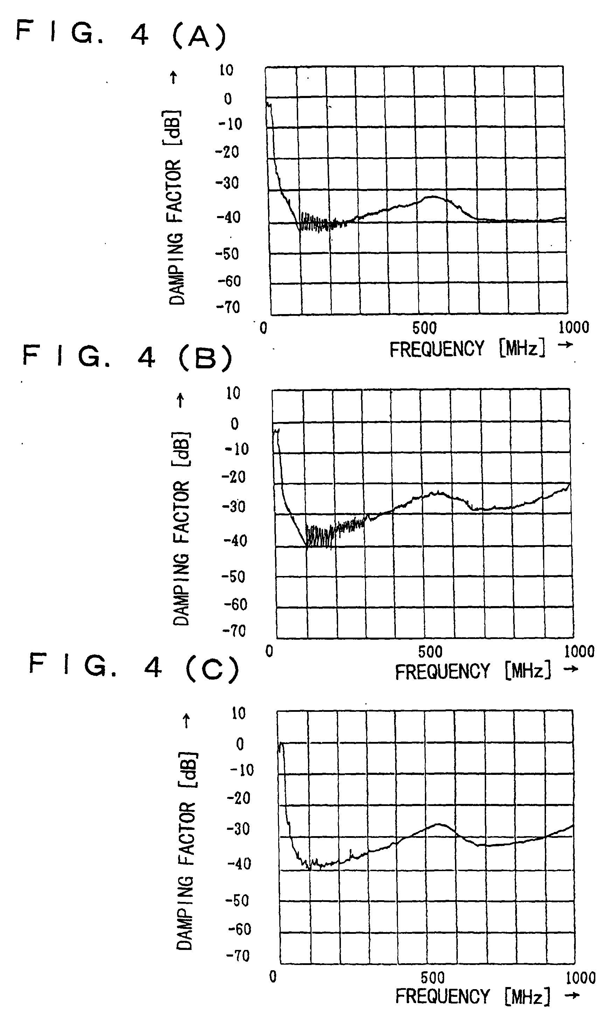

The electromagnetic wave-shielding material of the first embodiment of the present invention will be described hereafter with reference to FIGS. 1 to 4. FIG. 1 is a blending table indicating each of the blending example Nos. 1 to 9 for the electromagnetic wave-shielding material of the first embodiment, FIGS. 2(A), 2(B) and 2(C) are graphs of the electromagnetic wave-shielding properties of the blending example Nos. 1 to 3, FIGS. 3(A), 3(B) and 3(C) are graphs of the electromagnetic wave-shielding properties of the blending example Nos. 4 to 6, and FIG. 4(A), 4(B) and 4(C) are graphs of the electromagnetic wave-shielding properties of the blending example Nos. 7 to 9.

In each of the blending example Nos. 1 to 9 for the electromagnetic wave-shielding material of the first embodiment of the present invention, synthetic rubber is used as a basic material, a plural kinds of conductive agents (reinforcing agents) are added to the synthetic rubber so as to impart conductivity to the synthetic rubber, and sulfur is added to the synthetic rubber in an amount of from 1.5 to 18 weight parts relative to 100 weight parts of the synthetic rubber. The conductive agents are of two kinds of agent, i.e., conductive carbon and furnace black. The conductive carbon of 45 weight parts, 60 weight parts or 65 weight parts, and the furnace black of 20 weight parts or 10 weight parts are added relative to 100 weight parts of the above-mentioned synthetic rubber. Zinc white No. 3 as the curing assistant is added to the synthetic rubber as the basic material, together with softener, plasticizer, processing aid, age resistor and accelerator. There is used sulfur, which has been subjected to no surface treatment by means of oil or the like.

With respect to blending ratios of the blending agents to be added, the zinc white No. 3 as the curing assistant of 5 weight parts, the softener of 1 weight parts, dioctyl phthalate as the plasticizer of 20 weight parts or 25 weight parts, brown factice as the processing aid of 5 weight parts, chroman resin as the processing aid of 3 weight parts, the age resistor of 1 weight parts, dibenzothiazyl·disulfide (hereinafter referred to as "DM") of 1.5 weight parts and diphenylguanidine (hereinafter referred to as "D") of 0.5 weight parts are added relative to 100 weight parts of the synthetic rubber.

The electromagnetic wave-shielding material obtained by each of the blending examples was formed into a sheet body (having a thickness of 4 mm), and then was arranged in circumstances, in which the electromagnetic wave was generated so as to subjected to a test for the electromagnetic wave-shielding property. The results thereof are shown in FIGS. 2 to 4. Degree of the electromagnetic wave-shielding effect of each of these electromagnetic wave-shielding materials may be expressed by the damping factor, which is the ratio of an incident electric field from the front surface of a sample to an electric field after penetration of the sample. Here, there was investigated the damping property against the electromagnetic wave in the frequency range of from 0 to 1,000 MHz. The thus obtained property is expressed by a graph, in which an abscissa represents the frequency (MHz) of the electromagnetic wave and an ordinate represents the damping factor (dB).

In the blending example Nos. 1 to 4 as shown in FIG. 2 and FIG. 3(A), the blending ratio of sulfur is varied within a range of from 1.5 to 18 weight parts. With respect to the compared shielding property, the blending example No. 2 has the most excellent property.

In the blending example Nos. 5 to 7 as shown in FIGS. 3(B), 3 (C) and 4(A), there are applied blending ratios, which are different from those of the above-mentioned blending example Nos. 1 to 4, and the blending ratio of sulfur is determined as about 12 weight parts. In this case, it is possible to block off the electromagnetic wave in the high frequency band of at least 700 MHz and reduce the noise level to -30 dB. Especially in the blending example No. 6 in which sulfur of 12 weight parts is added relative to 100 weight parts of the synthetic rubber, there is obtained the result that the noise level of the electromagnetic wave in the high frequency band of at least 700 MHz can be reduced to -40 dB.

In the blending example Nos. 8 and 9 as shown in FIGS. 4(B) and 4(C), the blending ratio of the conductive carbon is increased in comparison with each of the above-mentioned blending examples so as to make investigation. In the blending example No. 9 in which sulfur of 12 weight parts is added relative to 100 weight parts of synthetic rubber, there can be obtained more excellent shielding effect than that of the blending example No. 8.

### [Second Embodiment]

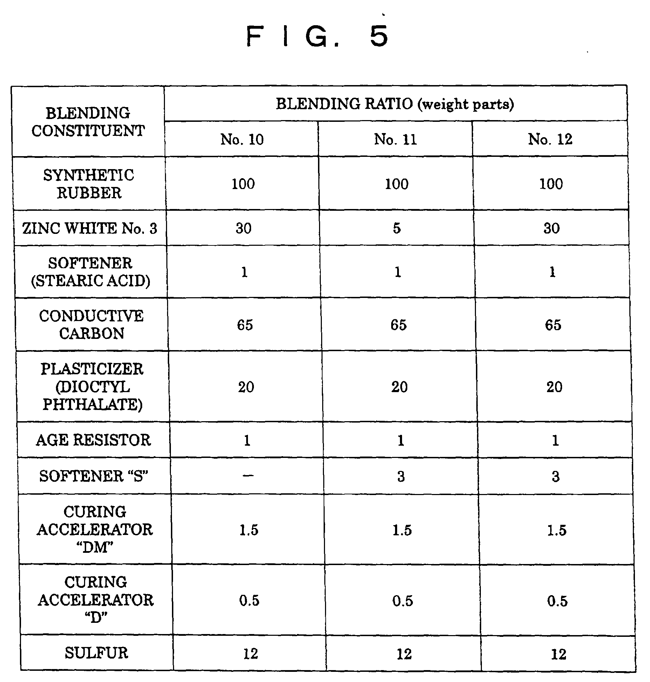

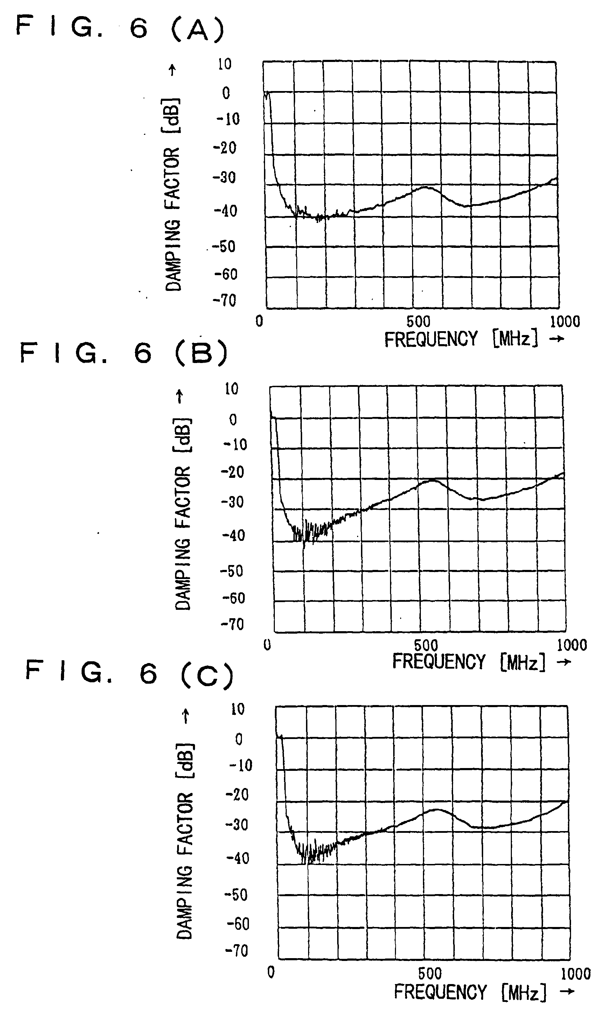

The electromagnetic wave-shielding material of the second embodiment of the present invention will be described hereafter with reference to FIGS. 5 and 6. FIG. 5 is a blending table indicating each of the blending example Nos. 10 to 12 for the electromagnetic wave-shielding material of the second embodiment, and FIGS. 6(A), 6(B) and 6(C) are graphs of the electromagnetic wave-shielding properties of the blending example Nos. 10 to 12.

In each of the blending example Nos. 10 to 12 for the electromagnetic wave-shielding material of the second embodiment of the present invention, zinc white No. 3, softener, conductive carbon, plasticizer, age resistor, the curing accelerator DM, and the curing accelerator D are added to synthetic rubber as in each of the blending examples of the first embodiment described above. The blending ratio of the zinc white is varied, and the product name "Struktol 60 NS" as the softener (hereinafter referred to as "S") manufactured by Schill & Seilacher Co. Ltd., is further added to the synthetic rubber, as the occasion demands. With respect to the blending ratios of the blending agents to be added, the zinc white No. 3 of 5 weight parts or 30 weight parts, the softener of 1 weight parts, the conductive carbon of 65 weight parts, the plasticizer of 20 weight parts, the age resistor of 1 weight parts, the curing accelerator DM of 1.5 weight parts, the curing accelerator D of 0.5 weight parts and sulfur of 12 weight parts are added relative to 100 weight parts of the synthetic rubber.

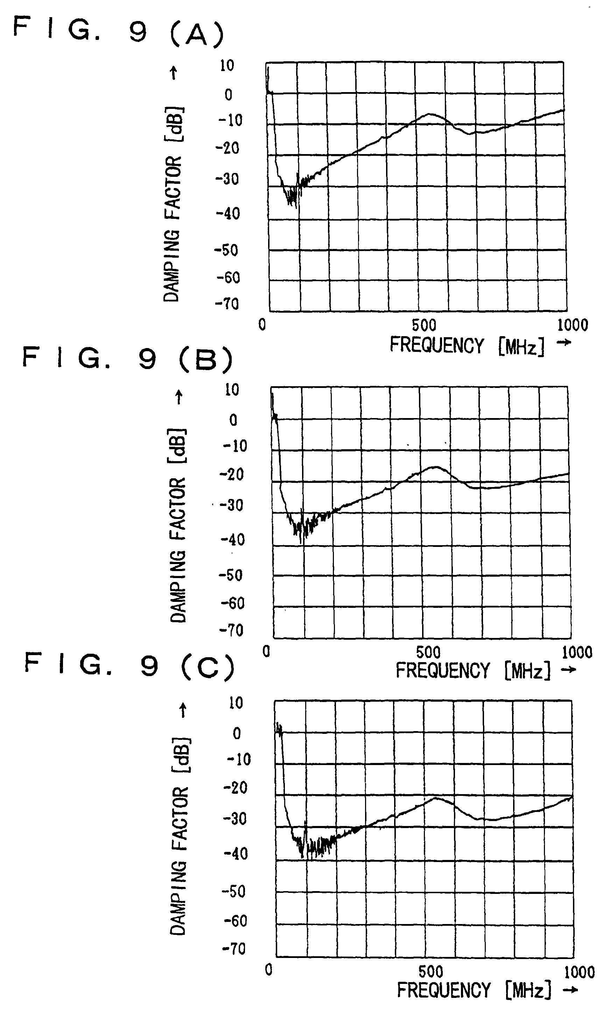

With respect to the blending ratio of the blending example No. 10 as shown in FIG. 6(A), the zinc white No. 3 is added in an amount of 30 weight parts relative to 100 weight parts of the synthetic rubber. Recognition was given that, according to the blending example No. 9, it was possible to reduce the noise level of the electromagnetic wave to about -30 dB in the entire frequency band from the low frequency to the high frequency, and according to the blending example No. 10, it was possible to reduce the noise level of the electromagnetic wave to under -30 dB in the entire frequency band from the low frequency to the high frequency, and an increased amount of the zinc white caused the shielding property to be improved, in comparison with the blending example No. 9 as shown in FIG. 9, which had the same blending ratios except for the zinc white (an added amount of the zinc white No. 3 was 5 weight parts).

The blending example No. 11 as shown in FIG. 6(B) can be obtained by adding further the above-mentioned softener S of 3 weight parts to the above-mentioned blending example No. 9. The blending example No. 12 as shown in FIG. 6(C) can be obtained by adding further the softener S of 3 weight parts to the above-mentioned blending example No. 10. Recognition was given that, according to the blending example Nos. 11 and 12 as shown in FIGS. 6(B) and 6(C), respectively, it was possible to reduce the noise level of the electromagnetic wave to about -30 dB in the entire frequency band from the low frequency to the high frequency, and the electromagnetic wave-shield property was reduced in comparison with the blending example No. 10 as shown in FIG. 6(A), in which only the zinc white No. 3 of 30 weight parts was added to the synthetic rubber. It is considered that the resistivity of the synthetic rubber is increased by impregnating the synthetic rubber with a solvent, fat and oil and the like, thus reducing the shielding property.

### [Third Embodiment]

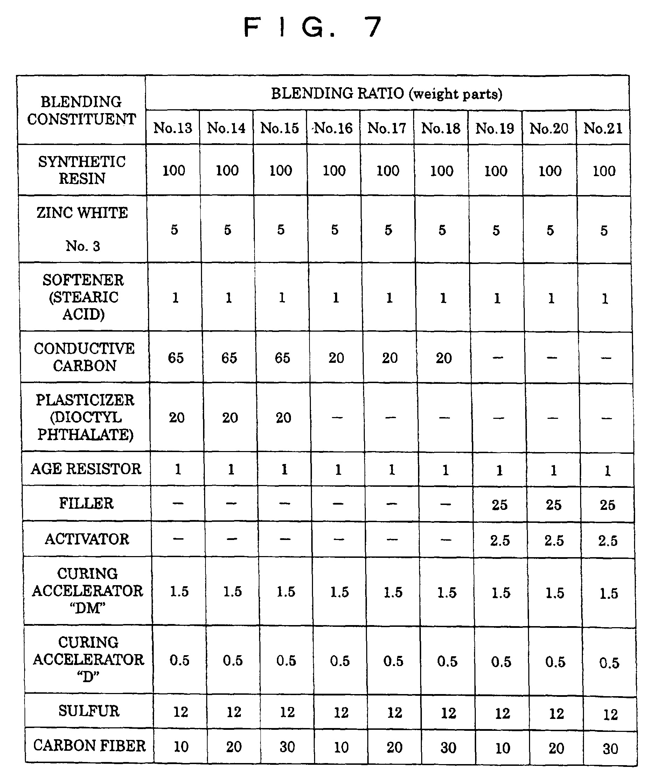

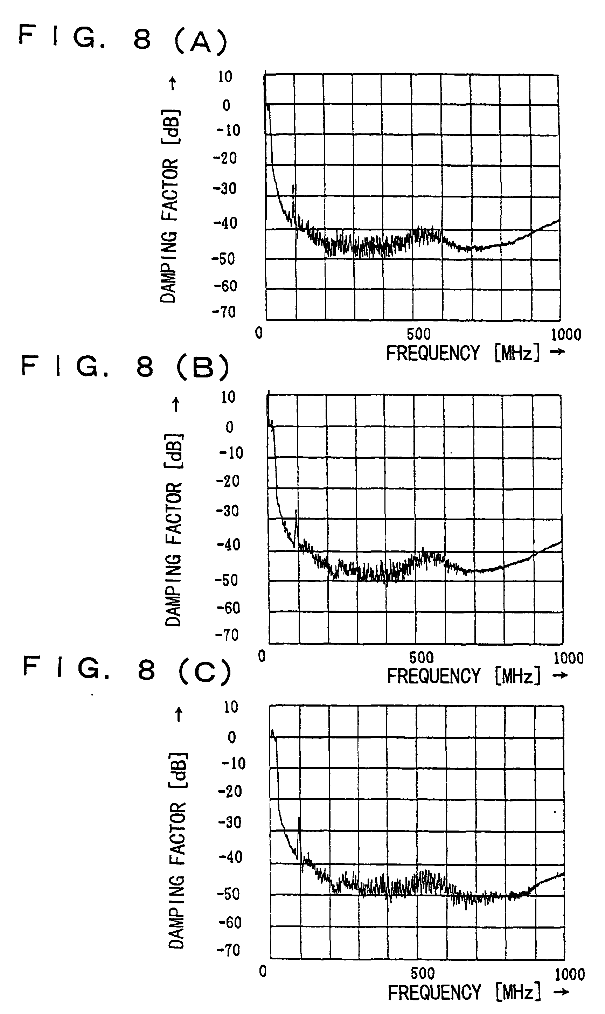

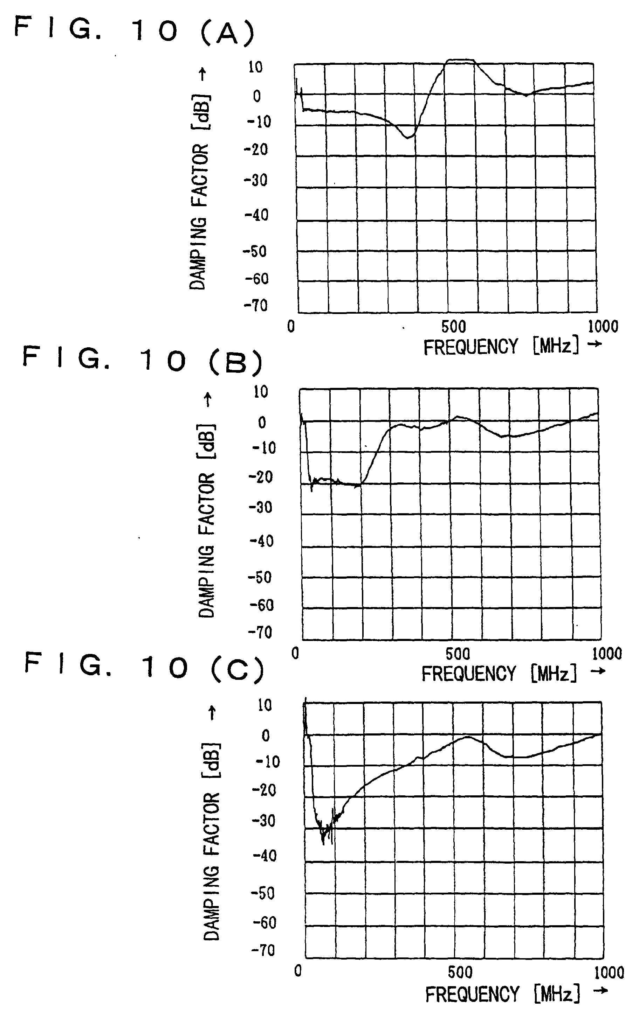

The electromagnetic wave-shielding material of the third embodiment of the present invention will be described hereafter with reference to FIGS. 7 to 10. FIG. 7 is a blending table indicating each of the blending example Nos. 13 to 21 for the electromagnetic wave-shielding material of the third embodiment, FIGS. 8(A), 8(B) and 8(C) are graphs of the electromagnetic wave-shielding properties of the blending example Nos. 13 to 15, FIGS. 9(A), 9(B) and 9(C) are graphs of the electromagnetic wave-shielding properties of the blending example Nos. 16 to 18, and FIGS. 10(A), 10(B) and 10(C) are graphs of the electromagnetic wave-shielding properties of the blending example Nos. 19 to 21.

In each of the blending example Nos. 13 to 18 for the electromagnetic wave-shielding material of the third embodiment of the present invention, zinc white No. 3, softener, conductive carbon, plasticizer, age resistor, the curing accelerator DM, and the curing accelerator D are added to synthetic rubber as in each of the blending examples of the first embodiment described above, and carbon fiber is further added in a prescribed amount.

With respect to the blending ratios of the blending agents to be added, the carbon fiber of 10, 20 or 30 weight parts, the conductive carbon of 65 or 20 weight parts, the zinc white of 5 weight parts, the softener of 1 weight parts, the age resistor of 1 weight parts, the curing accelerator DM of 1.5 weight parts, the curing accelerator D of 0.5 weight parts and sulfur of 12 weight parts are added relative to 100 weight parts of the synthetic rubber. When the conductive carbon of 65 weight parts is added, the plasticizer is added in an amount of 20 weight parts relative to 100 weight parts of the synthetic rubber.

There are also indicated, for the comparison purpose, blending example Nos. 19 to 21, in which no conductive carbon is added although the carbon fiber is added in an amount mentioned above. In the blending example Nos. 19 to 21, filler of 25 weight parts and activator of 2.5 weight parts are added relative to 100 weight parts of the above-mentioned synthetic rubber.

In the blending example Nos. 13 to 15 as shown in FIGS. 8(A), 8(B) and 8(C), the conductive carbon is added in an amount of 65 weight parts relative to 100 weight parts of the synthetic rubber, and the carbon fiber is added in amounts of 10, 20 and 30 weight parts, respectively. Recognition was given that, according to each of the blending example Nos. 13 to 15, it was possible to improve the electromagnetic wave-shielding property in the entire frequency band from the low frequency to the high frequency in comparison with the above-mentioned blending example No. 9 having the same blending constituents except for the carbon fiber, and that increase in an added amount of the carbon fiber to 30 weight parts caused the noise level of the electromagnetic wave to be reduced to under -40 dB and the addition of the carbon fiber caused a larger damping effect against the electromagnetic wave.

In the blending example Nos. 16 to 18 as shown in FIGS. 9(A), 9(B) and 9(C), the conductive carbon is added in an amount of 20 weight parts relative to 100 weight parts of the synthetic rubber, and the carbon fiber is added in amounts of 10, 20 and 30 weight parts, respectively. Recognition was given that, according to each of the blending example Nos. 16 to 18, the electromagnetic wave-shielding property in the entire frequency band from the low frequency to the high frequency was deteriorated, and that decrease in an added amount of the conductive carbon had the influence on the electromagnetic wave-shielding property.

In the blending example Nos. 19 to 21 as shown in FIGS. 10(A), 10(B) and 10(C), no conductive carbon is added, and the carbon fiber is added in amounts of 10, 20 and 30 weight parts, respectively. Recognition was given that, according to each of the blending example Nos. 19 to 21, the electromagnetic wave-shielding property in the entire frequency bend from the low frequency to the high frequency was deteriorated in comparison with the above-mentioned blending example Nos. 16 to 18, and that, even when the carbon fiber was added, a sufficient effect of the electromagnetic wave-shielding could not be obtained without simultaneous addition of the conductive carbon in a prescribed amount.

### [Fourth Embodiment]

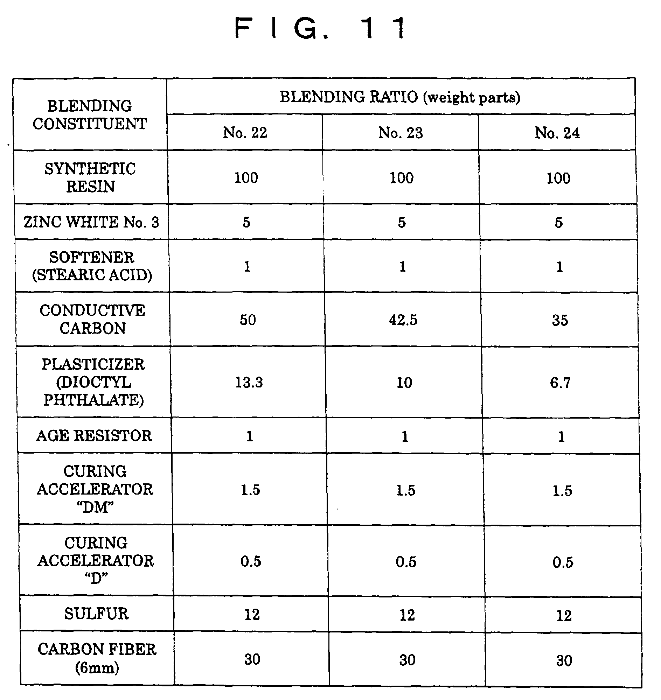

The electromagnetic wave-shielding material of the fourth embodiment of the present invention will be described hereafter with reference to FIGS. 11 and 12. FIG. 11 is a blending table indicating each of the blending example Nos. 22 to 24 for the electromagnetic wave-shielding material of the fourth embodiment, and FIGS. 12(A), 12(B) and 12(C) are graphs of the electromagnetic wave-shielding properties of the blending example Nos. 22 to 24.

In each of the blending example Nos. 22 to 24 for the electromagnetic wave-shielding material of the fourth embodiment of the present invention, zinc white No. 3, softener, conductive carbon, plasticizer, age resistor, the curing accelerator DM, and the curing accelerator D are added to synthetic rubber as in each of the blending examples of the first embodiment described above, and carbon fiber is further added and an added amount of the conductive carbon is varied.
With respect to the blending ratios of the blending agents to be added, the zinc white No. 3 of 5 weight parts, the softener of 1 weight parts, the conductive carbon of 50, 42.5 or 35 weight parts, the plasticizer of 13.3, 10 or 6.7 weight parts, the age resistor of 1 weight parts, the curing accelerator DM of 1.5 weight parts, the curing accelerator D of 0.5 weight parts, sulfur of 12 weight parts and the carbon fiber of 30 weight parts are added relative to 100 weight parts of the synthetic rubber.

In the blending ratio of the blending example No. 22 as shown in FIG. 12(A), the conductive carbon of 50 weight parts and the plasticizer of 13.3 weight parts are added relative to 100 weight parts of the synthetic rubber. In the blending ratio of the blending example No. 23 as shown in FIG. 12(B), the conductive carbon of 42.5 weight parts and the plasticizer of 10 weight parts are added relative to 100 weight parts of the synthetic rubber. According to these blending example Nos. 22 and 23, almost the same properties are obtained, although the damping effect against the electromagnetic wave in the high frequency of at least 600 MHz is slightly reduced in comparison with the blending example No. 15 as shown in FIG. 8(C), which has the same blending ratios except for the conductive carbon and the plasticizer.

In the blending ratio of the blending example No. 24 as shown in FIG. 12(C), the conductive carbon of 35 weight parts and the plasticizer of 6.7 weight parts are added relative to 100 weight parts of the synthetic rubber. Recognition was given that, according to the above-mentioned blending example No. 24, the shielding property in the frequency band of at least 200 MHz was apparently deteriorated in comparison with the blending example Nos. 22, 23 and 15, and that there existed a lower limit of the blending ratio of the conductive carbon in order to obtain a sufficient shielding property.

The electromagnetic wave-shielding property in the entire frequency band from the low frequency to the high frequency is improved according as the blending ratio of the conductive carbon increases. With respect to the blending ratio of the conductive carbon, there are requirements that the kneading operation of the conductive carbon with the synthetic rubber may easily be carried out and there is no problem in the manufacturing process. The proper ratio of the conductive carbon is about 65 weight parts relative to 100 weight parts of the synthetic rubber.

### [Fifth Embodiment]

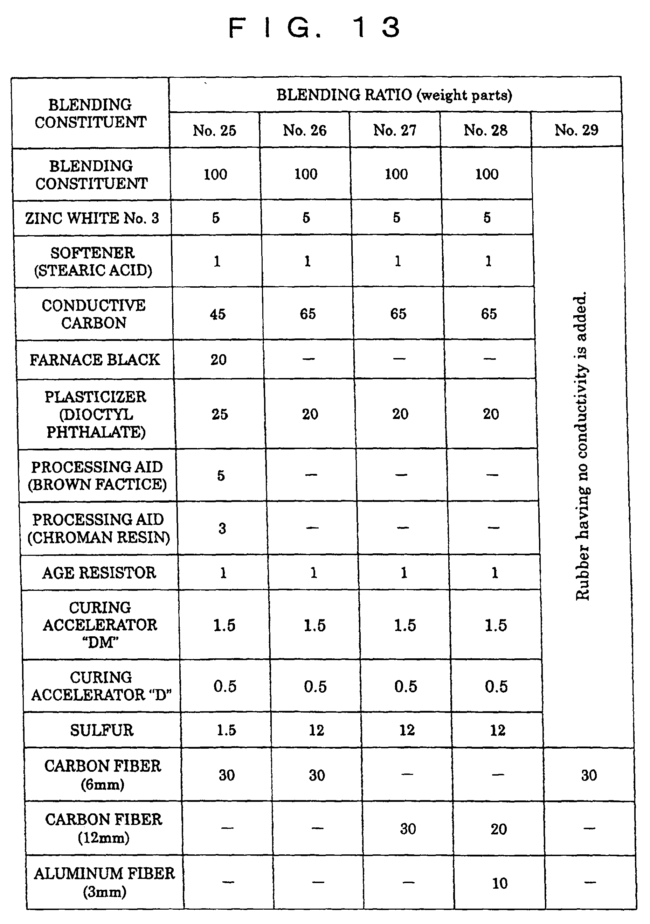

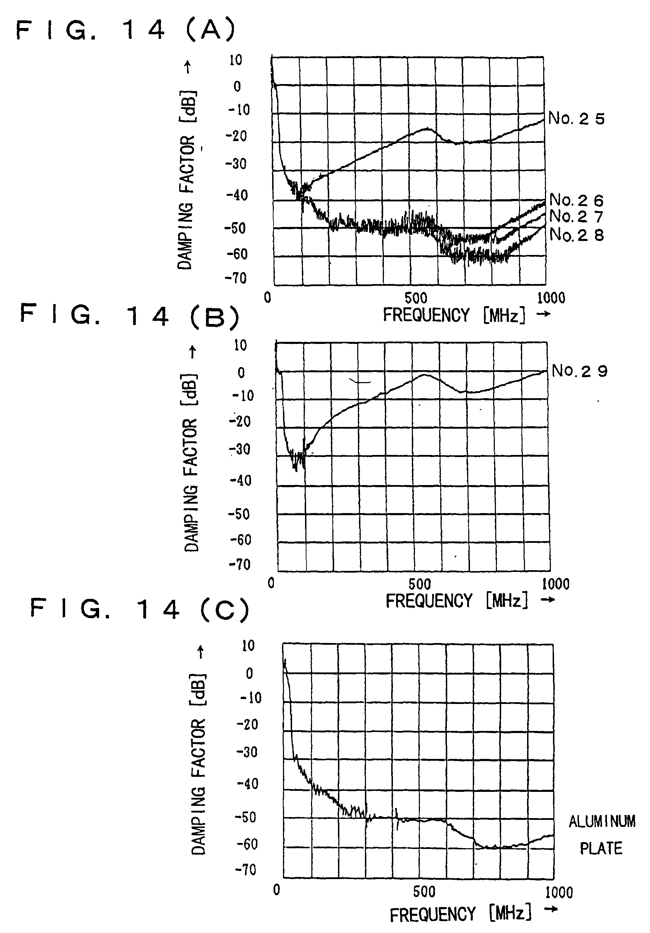

The electromagnetic wave-shielding material of the fifth embodiment of the present invention will be described hereafter with reference to FIGS. 13 and 14. FIG. 13 is a blending table indicating each of the blending example Nos. 25 to 29 for the electromagnetic wave-shielding material of the fifth embodiment, and FIGS. 14(A), 14(B) and 14(C) are graphs of the electromagnetic wave-shielding properties of the blending example Nos. 25 to 29 in comparison with the electromagnetic wave-shielding property of an aluminum plate.

In each of the blending example Nos. 25 to 28 for the electromagnetic wave-shielding material of the fifth embodiment of the present invention, zinc white No. 3, softener, conductive carbon, plasticizer, age resistor, the curing accelerator DM, and the curing accelerator D are added to synthetic rubber as in each of the blending examples of the first embodiment described above so as to make a basic blending, and in addition to the basic blending, carbon fiber of 30 or 20 weight parts is added relative to 100 weight parts of the synthetic rubber, and an aluminum fiber having a length of 3 mm is added in an amount of 10 weight parts as the occasion demands. There are used two kinds of carbon fiber, which has a fiber length of 6 mm or 12 mm.

In the blending example No. 25 as shown in FIG. 14A), the carbon fiber having a fiber length of 6 mm is added to the constituents of the blending example No. 1 as shown in FIG. 2(A), in an amount of 30 weight parts relative to 100 weight parts of the synthetic rubber. Recognition was given that, according to the blending example No. 25, a sufficient electromagnetic wave-shielding property could not be obtained, although the shielding property was slightly improved in comparison with the blending example No. 1, and that the good electromagnetic wave-shielding property could not be obtained by blending only the carbon fiber, in case that no carbon fiber was added and a prescribed damping effect could not be obtained.

In the blending example No. 26 as shown in FIG. 14(A), the carbon fiber having a fiber length of 6 mm is added to the constituents of the blending example No. 9 as shown in FIG. 4(C), in an amount of 30 weight parts relative to 100 weight parts of the synthetic rubber. In the blending example No. 27, the carbon fiber having a fiber length of 12 mm (and a thickness of 7 µm²) is added to the constituents of the above-mentioned blending example No. 9 in an amount of 30 weight parts relative to 100 weight parts of the synthetic rubber. In the blending example No. 28, the carbon fiber of 20 weight parts having a fiber length of 12 mm (and a thickness of 7 µm²) and an aluminum fiber of 10 weight parts having a fiber length of 3 mm are added to the constituents of the above-mentioned blending example No. 9 relative to 100 weight parts of the synthetic rubber.

The blending examples Nos. 26 to 28 are different from each other in blending ratio. Recognition was given that, according to the blending example No. 26, the near property to the electromagnetic wave-shielding property of the aluminum plate as shown in FIG. 14(C) could be obtained in the entire frequency band of from the low frequency to the high frequency by adding the carbon fiber having the fiber length of 6 mm in an amount of 30 weight parts in addition to the basic blending of the blending example No. 9.

Recognition was given that, according to the blending example No. 27, the property, which was near to the electromagnetic wave-shielding property of the aluminum plate as shown in FIG. 14(C) and was more excellent than that of the blending example No. 26 in the high frequency band of over 800 MHz, could be obtained in the entire frequency band of from the low frequency to the high frequency by adding the carbon fiber having the fiber length of 12 mm in an amount of 30 weight parts in addition to the basic blending of the blending example No. 9.

Recognition was given that, according to the blending example No. 28, almost the same property as the electromagnetic wave-shielding property of the aluminum plate as shown in FIG. 14(C) could be obtained in the entire frequency band of from the low frequency to the high frequency by adding the carbon fiber of 20 weight parts having the fiber length of 12 mm and the aluminum fiber of 10 weight parts having the fiber length of 3 mm in addition to the basic blending of the blending example No. 9.

There is also indicated, for the comparison purpose, a blending example No. 29, in which a carbon fiber of 30 weight parts having a fiber length of 6 mm is added to a synthetic rubber having no conductivity. According to the blending example No. 29, recognition was given that no electromagnetic wave-shielding effect by means of the carbon fiber and that the good electromagnetic wave-shielding property could not be obtained by blending only the carbon fiber, in case that no carbon fiber was added and a prescribed electromagnetic wave-damping effect could not be obtained

Recognition was given from each of the electromagnetic wave-shielding properties of the blending example Nos. 25 to 29 that, on the premise that the material according to the basis blending, which had been obtained by adding the zinc white No. 3, the softener, the conductive carbon, the plasticizer, the age resistor, the curing accelerator DM, the curing accelerator D and sulfur to the synthetic rubber, had the electromagnetic wave-shielding property of from -20 dB to -30 dB, the carbon fiber (preferably having a long fiber-length and permitting to impart the high conductivity to the synthetic rubber) and the aluminum fiber were added in prescribed amounts to the above-mentioned basis blending, in order to obtain the electromagnetic wave-shielding property, which was equal to that of the metallic plate such as an aluminum plate.

### [Sixth Embodiment]

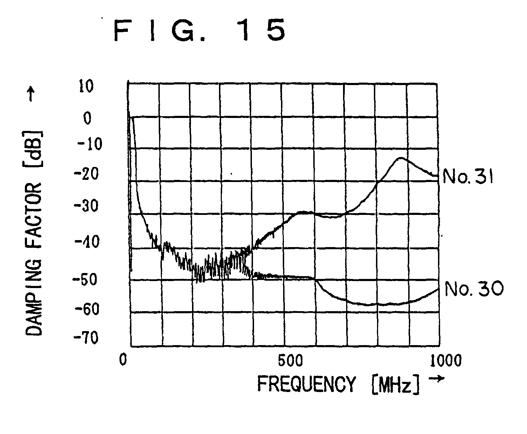

The electromagnetic wave-shielding material of the sixth embodiment of the present invention will be described hereafter with reference to FIG. 15. FIG. 15 is a comparative graph of the electromagnetic wave-shielding property of each of the composition example Nos. 30 and 31.

In the blending example No. 30 for the electromagnetic wave-shielding material of the sixth embodiment of the present invention, zinc white No. 3, softener, conductive carbon, plasticizer, age resistor, the curing accelerator DM, the curing accelerator D and sulfur are added to synthetic rubber as in each of the blending examples of the first embodiment described above so as to make a basic blending, and a net member formed of stainless steel is held between members formed of the material according to the above-mentioned basis blending, so as to be formed into a sheet body. There is also indicated the composition example No. 31 as a comparative example, in which the above-mentioned net member formed of stainless steel is held between members formed of synthetic rubber-blending material having no conductivity, which is different from the composition example No. 30, so as to be formed into a sheet body.

Recognition was given that, according to the composition example No. 30 as shown in FIG. 15, almost the same property as the electromagnetic wave-shielding property of the aluminum plate as shown in FIG. 14 (C) could be obtained. To the contrary, recognition was given that the composition example No. 31 had a small electromagnetic wave-shielding effect in the high frequency, and namely, it had a filtering effect of causing the electromagnetic wave in the high frequency band to selectively penetrate, although there could be obtained almost the same property as the electromagnetic wave-shielding property of the aluminum plate in the low frequency band.

### [Seventh Embodiment]

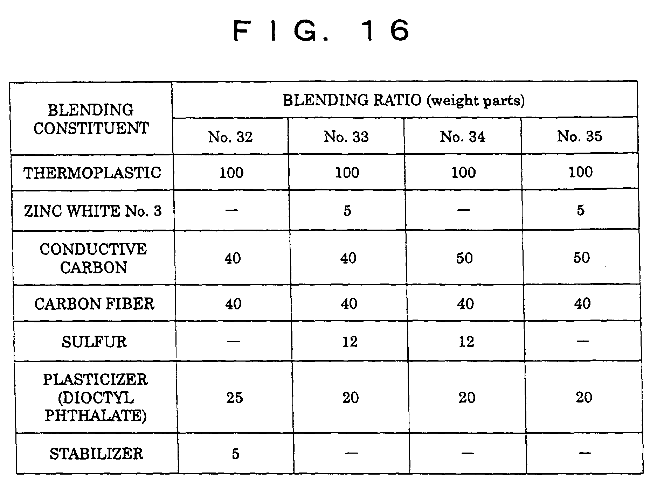

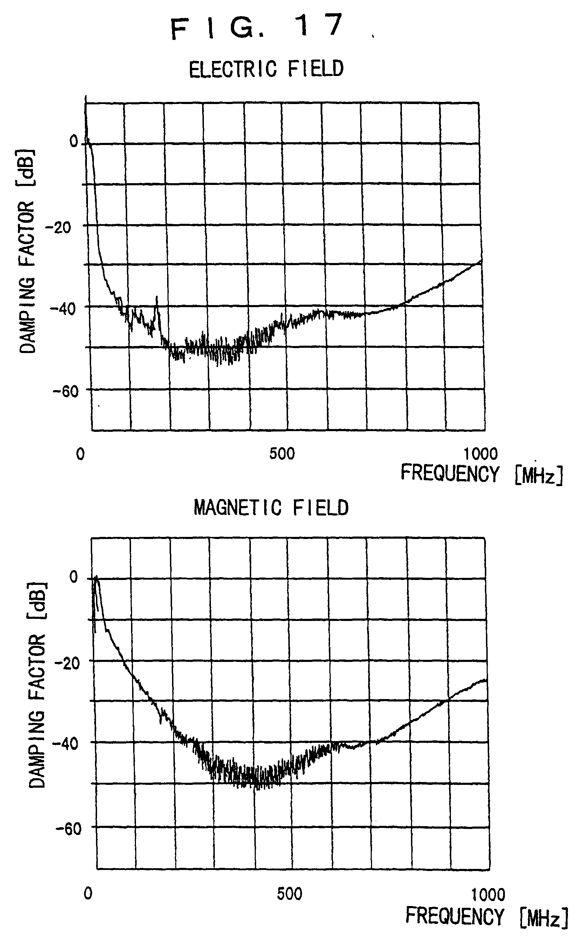

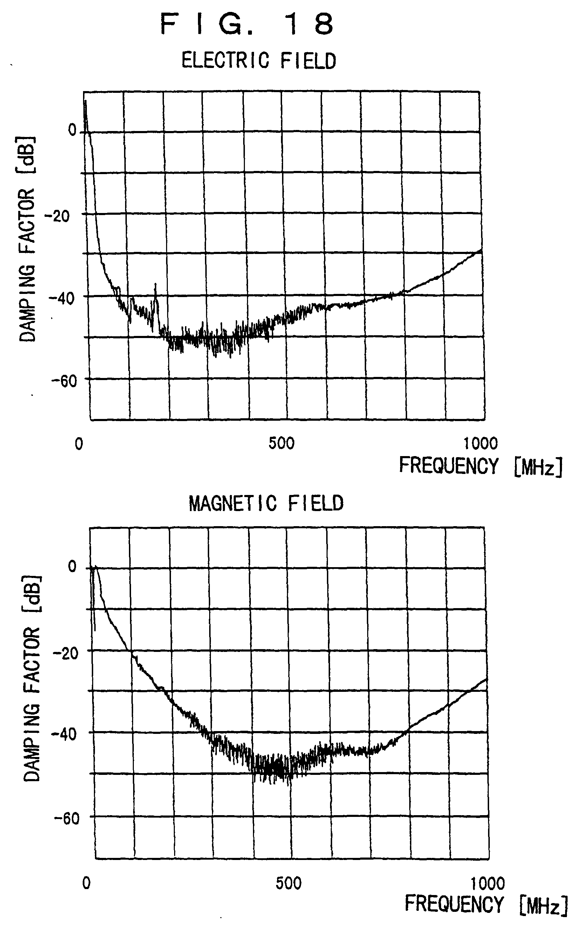

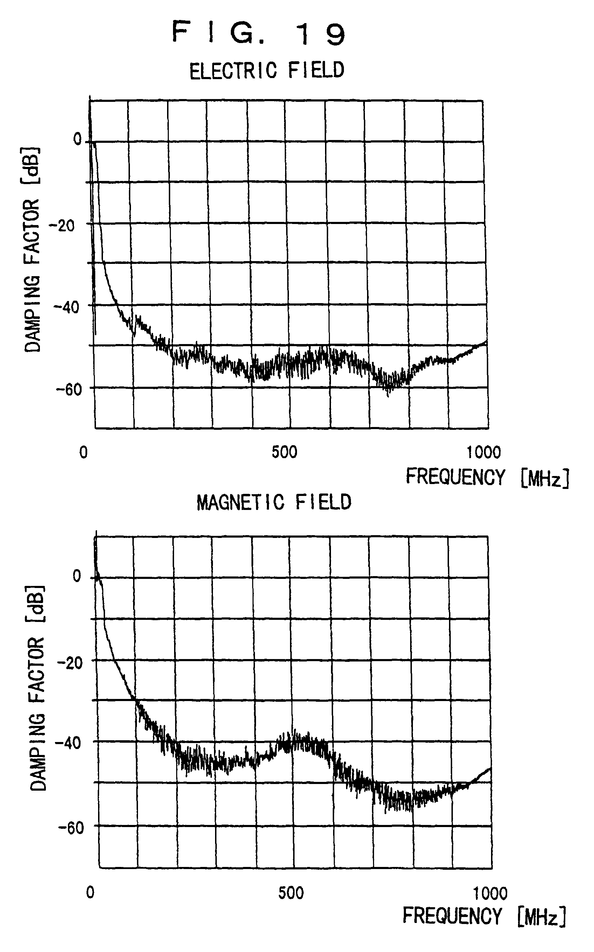

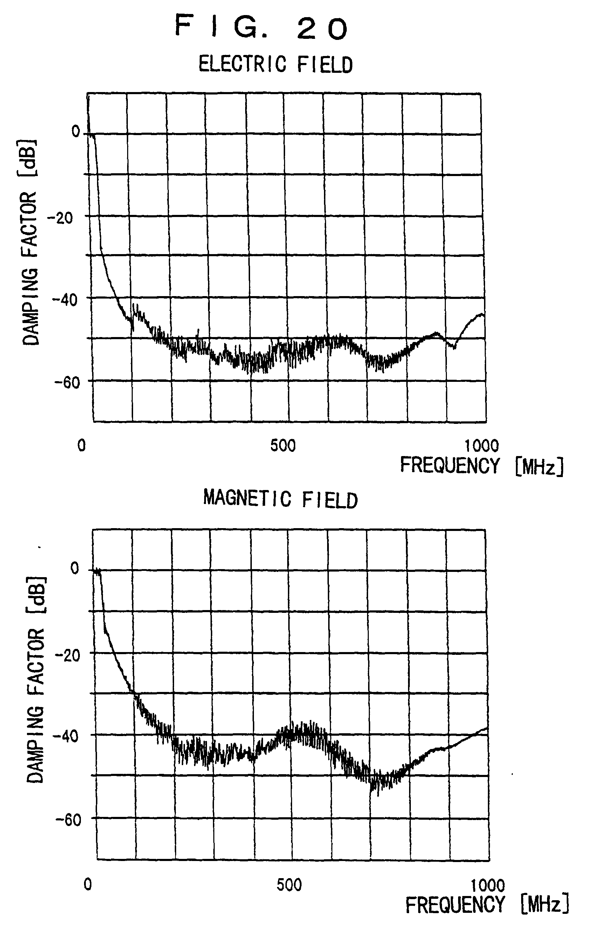

The electromagnetic wave-shielding material of the seventh embodiment of the present invention will be described hereafter with reference to FIGS. 16 to 20. FIG. 16 is a blending table indicating each of the blending example Nos. 32 to 35 for the electromagnetic wave-shielding material of the seventh embodiment, FIG. 17 is a graph of the electromagnetic wave-shielding property of the blending example No. 32, FIG. 18 is a graph of the electromagnetic wave-shielding property of the blending example No. 33, FIG. 19 is a graph of the electromagnetic wave-shielding property of the blending example No. 34 and FIG. 20 is a graph of the electromagnetic wave-shielding property of the blending example No. 35.

In each of the blending example Nos. 32 to 35 for the electromagnetic wave-shielding material of the seventh embodiment of the present invention, conductive agents are added to plastic material as the basic material so as to impart the conductivity thereto, and prescribed amounts of sulfur and zinc white are added as the occasion demands.

As the plastic material, there is used thermoplastic polyester resin, which is one of thermoplastic resins, which are easily formable by a press molding, an injection molding, an extrusion molding or the like. There may however be used as the above-mentioned plastic material thermosetting resin such as unsaturated polyester resin, polyurethane resin or the like, or engineering plastic such as polyamide resin, polycarbonate or the like.

Conductive carbon and carbon fiber are used as the above-mentioned conductive agents. The conductive carbon and the carbon fiber are added in amounts of from 35 to 65 weight parts and of from 10 to 40 weight parts, respectively, relative to 100 weight parts of the plastic material, so that an appropriate shielding effect can be obtained, the kneading operation of them may easily be carried out and there is no problem in the manufacturing process. The above-mentioned sulfur is added in an amount of from 4 to 16 weight parts relative to 100 weight parts of the plastic material, and the above-mentioned zinc white is added in an amount of from 3 to 30 weight parts relative to 100 weight parts of the plastic material. In addition to the above-mentioned additives, plasticizer, stabilizer and the like may be added to the plastic material.

The combination and the blending ratios of the constituents in each of the blending example Nos. 32 to 35 will be described below (see FIG. 16). In the blending example No. 32, oil furnace black (the product name "Ketjen Black EC" manufactured by Lion Co. Ltd.) and the carbon fiber as the above-mentioned conductive carbon are added both in an amount of 40 weight parts relative to 100 weight parts of the above-mentioned plastic material.

In the blending example No. 33, zinc white No. 3 and sulfur are added to the constituents of the above-mentioned blending example No. 32 in amounts of 5 weight parts and 12 weight parts, respectively, relative to 100 weight parts of the plastic material.

In the blending example No. 34, the above-mentioned conductive carbon is added to the above-mentioned blending example No. 32 in an amount of 50 weight parts relative to 100 weight parts of the plastic material, and sulfur is added in an amount of 12 weight parts relative to 100 weight parts of the plastic material.

In the blending example No. 35, zinc white No. 3 as a substitute for sulfur is added, in the above-mentioned blending example No. 34, in an amount of 5 weight parts relative to 100 weight parts of the plastic material.

In order to prepare the electromagnetic wave-shielding material of each of the blending examples, thermoplastic polymer is first applied on rotating rollers for rough kneading to carry out a kneading step. In case that the zinc white is used, it is first added to the polymer applied on the rollers, and then the conductive carbon is added thereto. In case that sulfur is used, it is then added and the carbon fiber is finally added. The kneading step by means of the rollers is continuously carried out so that the additives are completely dispersed into the polymer. When the kneaded mixture of the polymer and the additives has a prescribed thickness, such a kneaded mixture is removed from the rollers to prepare a sheet of the mixture. Such a sheet is subjected to a pressing step at a prescribed temperature and under a prescribed pressure to prepare the sample having s sheet-shape. The sample has a thickness of 4 mm.

The electromagnetic wave-shielding material of each of the blending examples was located on a place where the electromagnetic wave was generated, so as to make investigation of the electromagnetic wave-shielding property. The results are shown in FIGS. 17 to 20. Degree of the electromagnetic wave-shielding effect of each of these electromagnetic wave-shielding materials may be expressed by the damping factor, which is the ratio of an incident electric field from the front surface of a sample to an electric field after penetration of the sample. Here, there was investigated the damping property against the electromagnetic wave in the frequency range of from 0 to 1,000 MHz. The obtained property is expressed in the form of a graph, in which the abscissa indicates the frequency (MHz) of the electromagnetic wave and the ordinate indicates the damping factor (dB).

As shown in FIG. 17, recognition was given that, according to the blending example No. 32, there could be obtained the damping factor under -30 dB within the almost entire frequency band in the graph, and that the electromagnetic wave-shielding effect could be obtained in the high frequency band of hundreds MHz.

As shown in FIG. 18, according to the blending example No. 33, in which the zinc white and sulfur are added to the constituents of the blending example No. 32, the damping effect against the magnetic field can slightly be improved in comparison with the blending example No. 32, although there is almost no difference in the damping effect against the electric field between the blending example Nos. 32 and 33. Recognition was therefore given that the shielding effect could be improved by adding any one of zinc white and sulfur or both of them.

As shown in FIG. 19, with respect to the electromagnetic wave-shielding property of the blending example No. 34, the damping effect can be improved in the band range of at least 200 MHz for the electric field and at least 600 MHz for the magnetic field, and in particularly, the damping effect of under -50 dB can be obtained in the frequency of at least 200 MHz for the electric field. Recognition was therefore given that the electromagnetic wave-shielding effect in the high frequency band of hundreds MHz could be remarkably improved by increasing an added amount of the conductive carbon.

In addition, as shown in FIG. 20, according to the blending example No. 35, the damping effect is slightly reduced in the high frequency band in comparison with the above-mentioned blending example No. 34. Recognition was therefore given that, even when the zinc white was added, the electromagnetic wave-shielding property could not be improved without adding sulfur, and that the combination of the zinc white and sulfur had influence on the electromagnetic wave-shielding property.

According to the electromagnetic wave-shielding material, which is obtained by adding the conductive carbon, the carbon fiber, sulfur and the zinc white to the plastic material in prescribed amounts, there can be obtained a prescribed electromagnetic wave-shielding effect in the high frequency band of hundreds MHz, and the use of the plastic material as the basic material causes an easy formation of the electromagnetic wave-shielding material having a various shape. Such shielding material is lightweight and excellent in handling property, and can be manufactured at a low cost.

### [Eighth Embodiment]

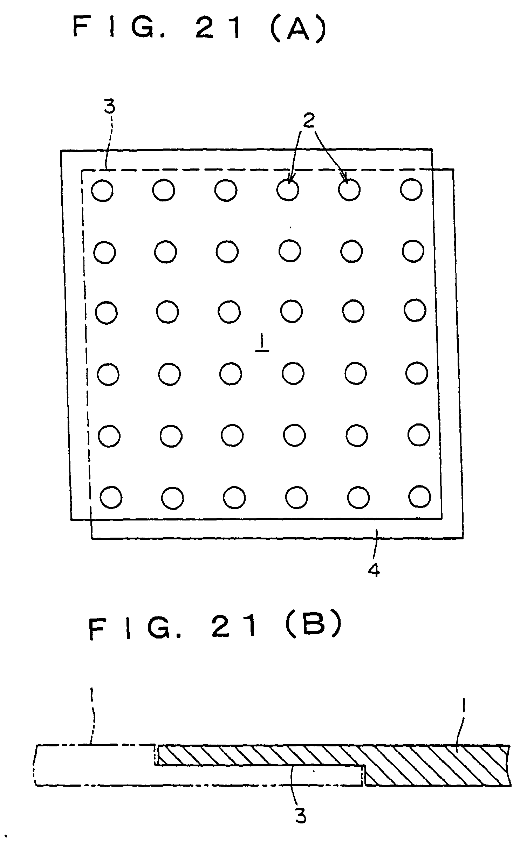

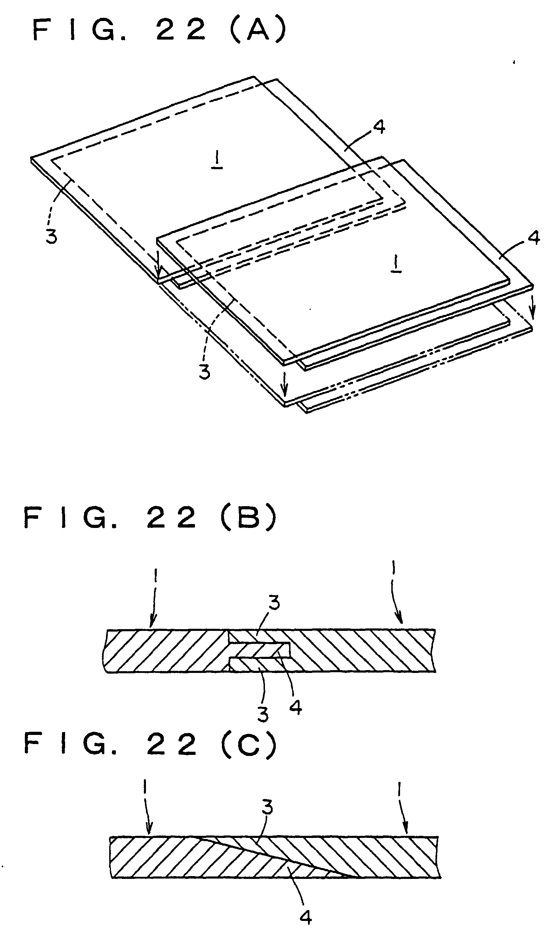

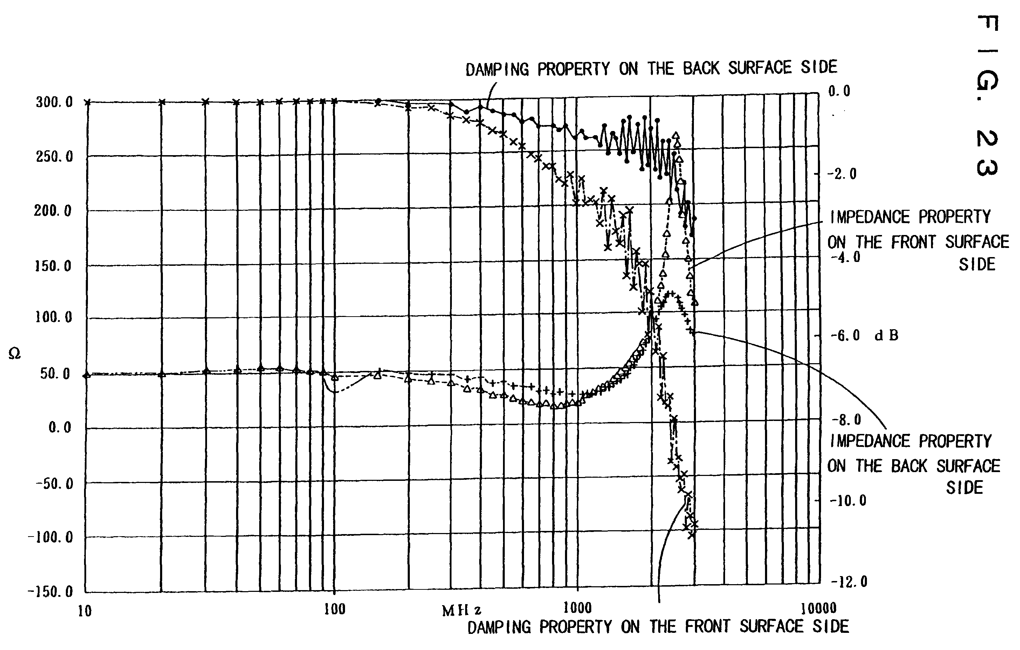

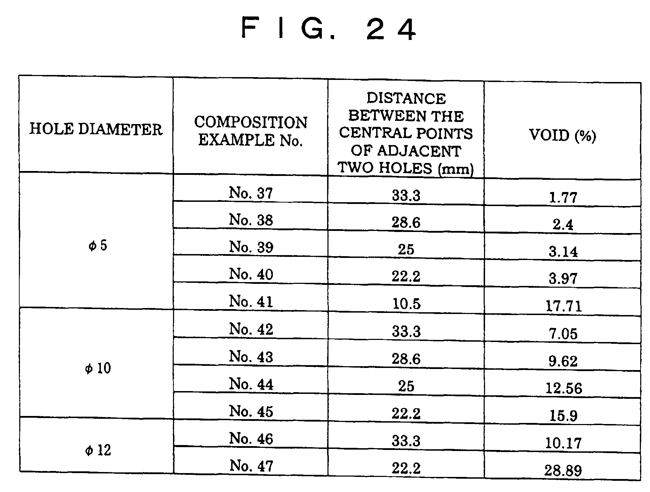

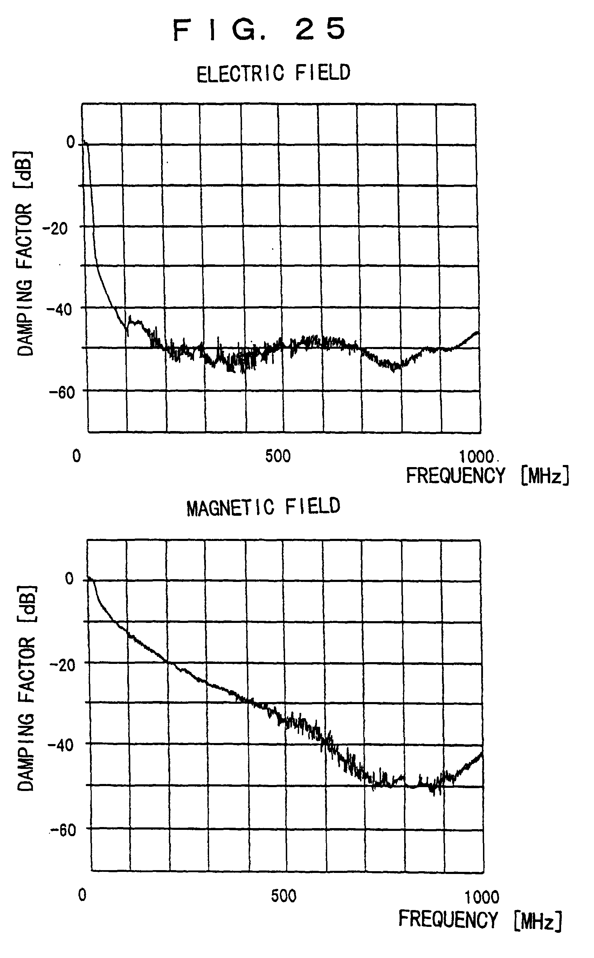

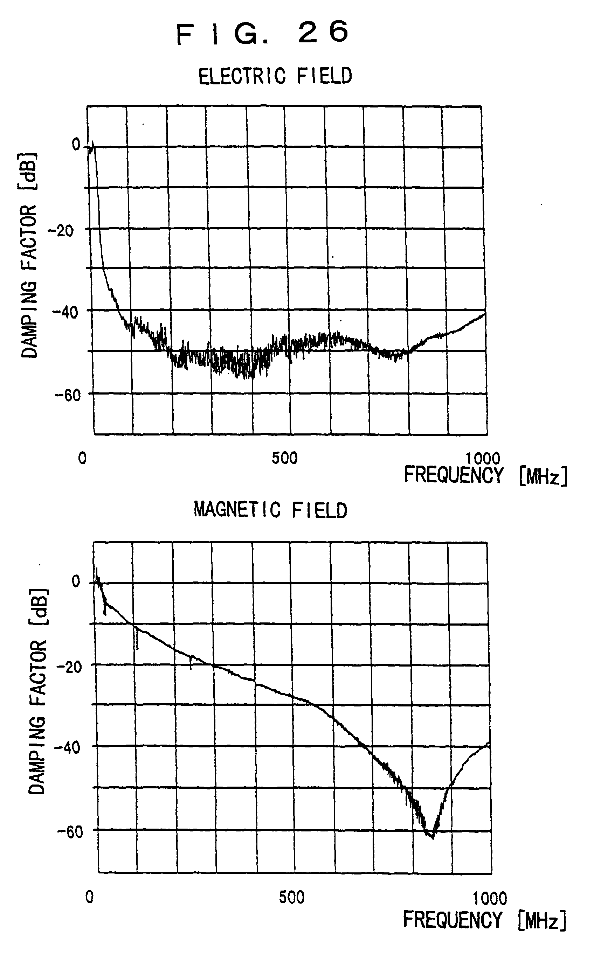

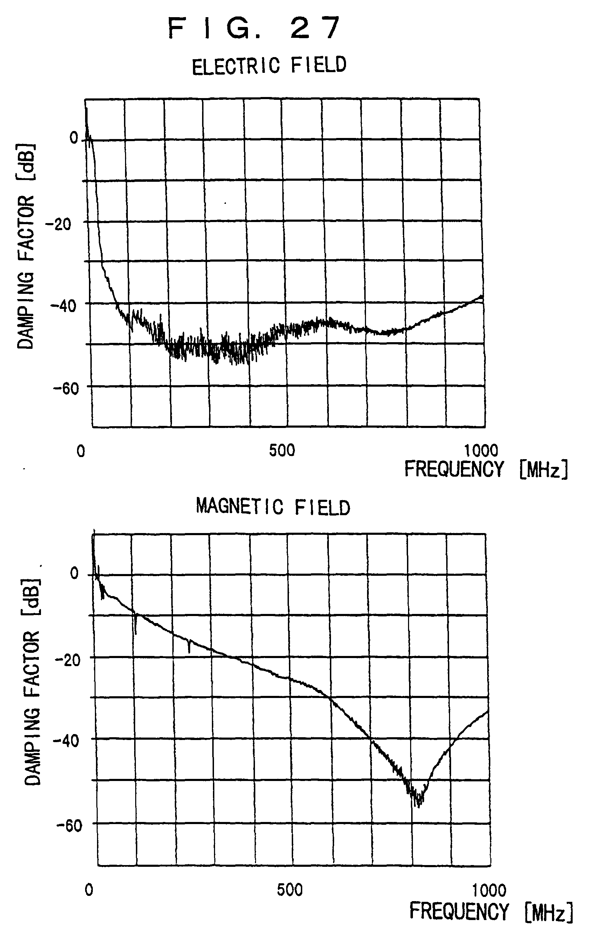

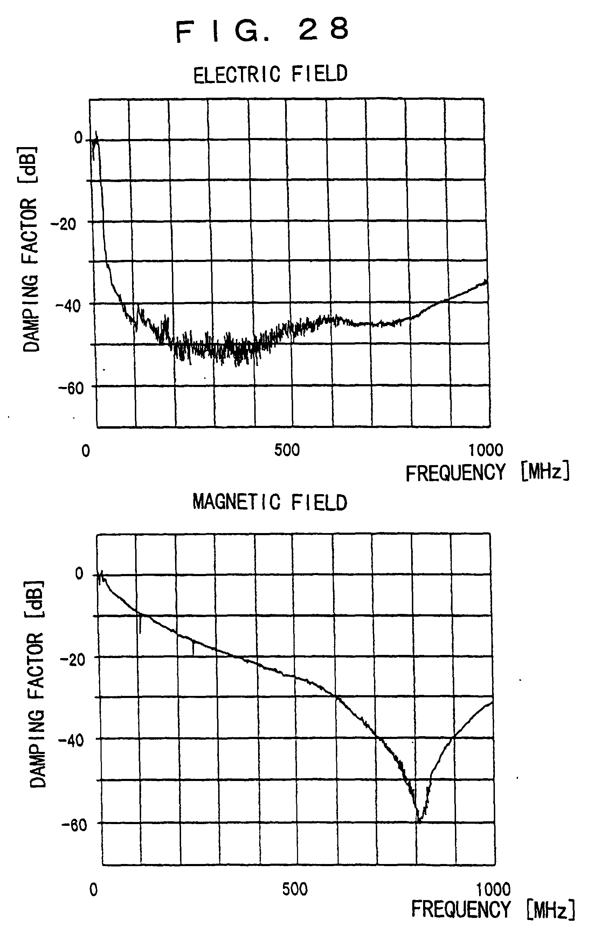

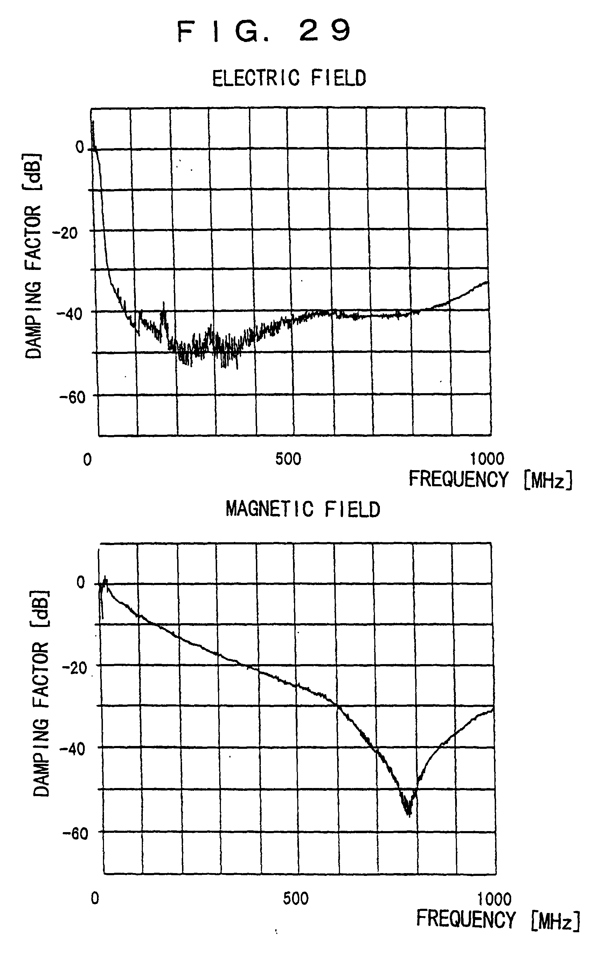

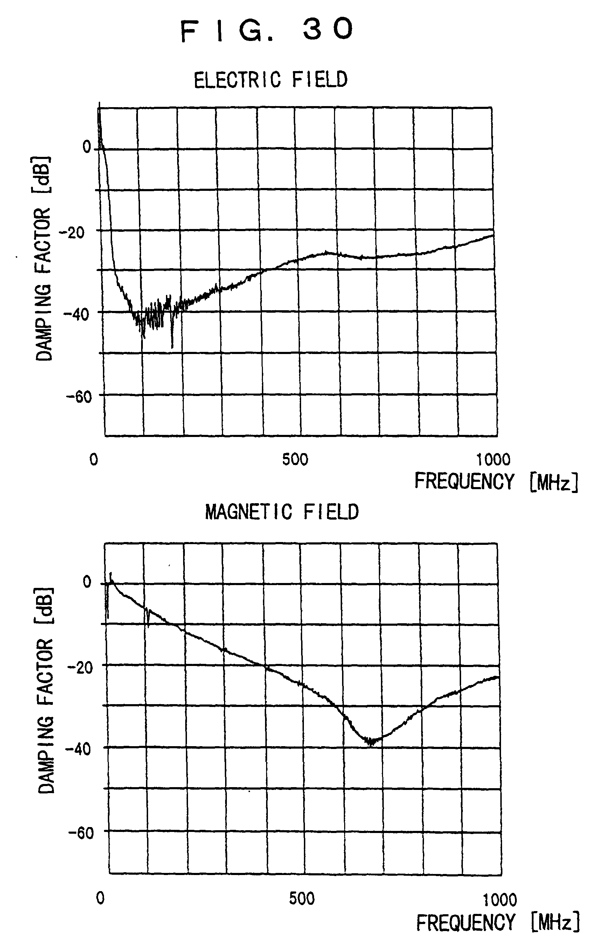

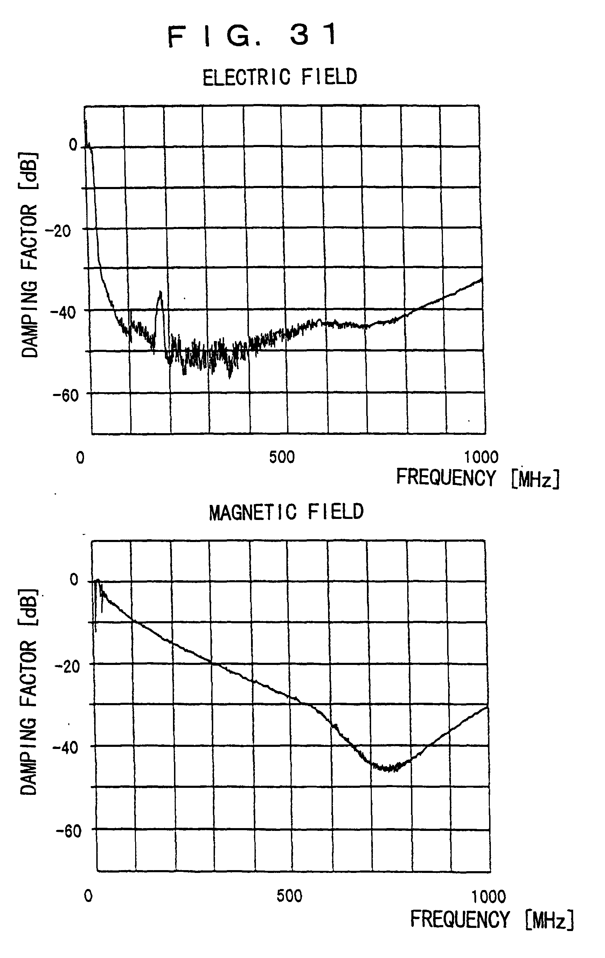

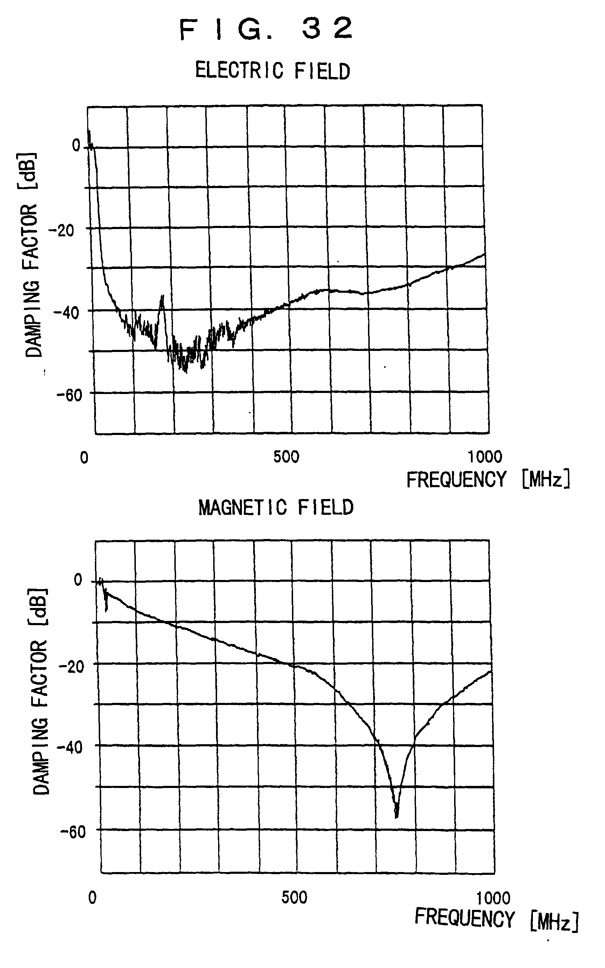

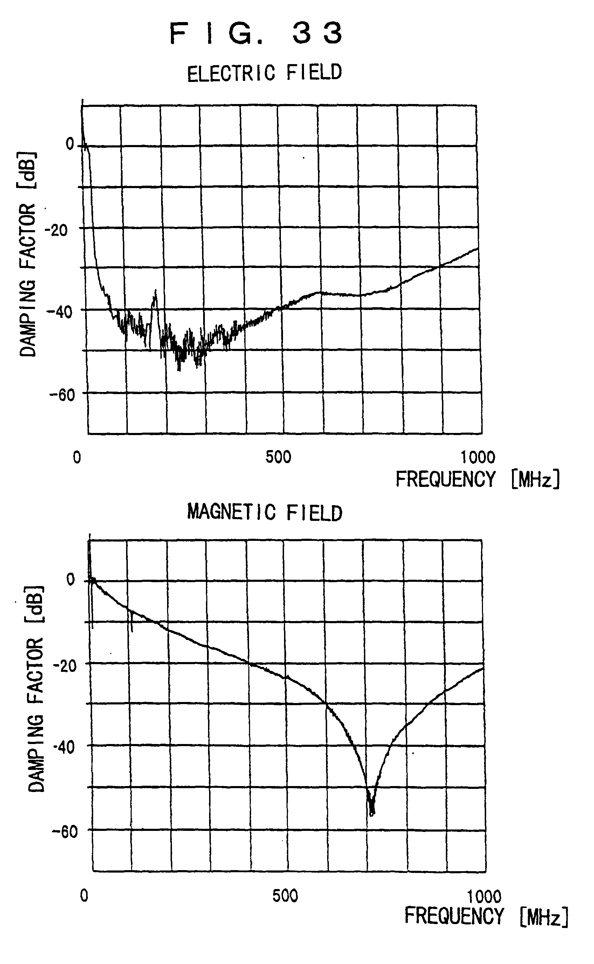

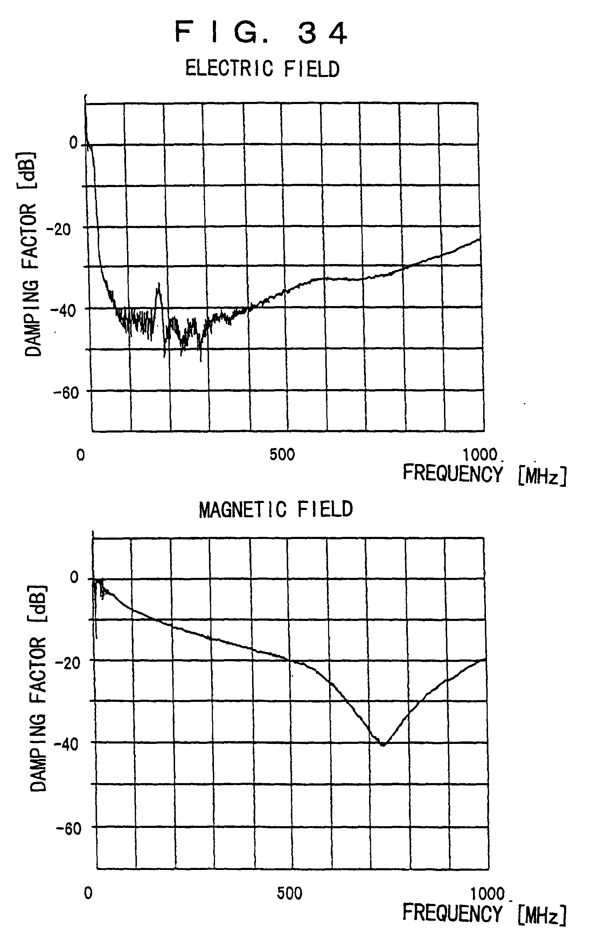

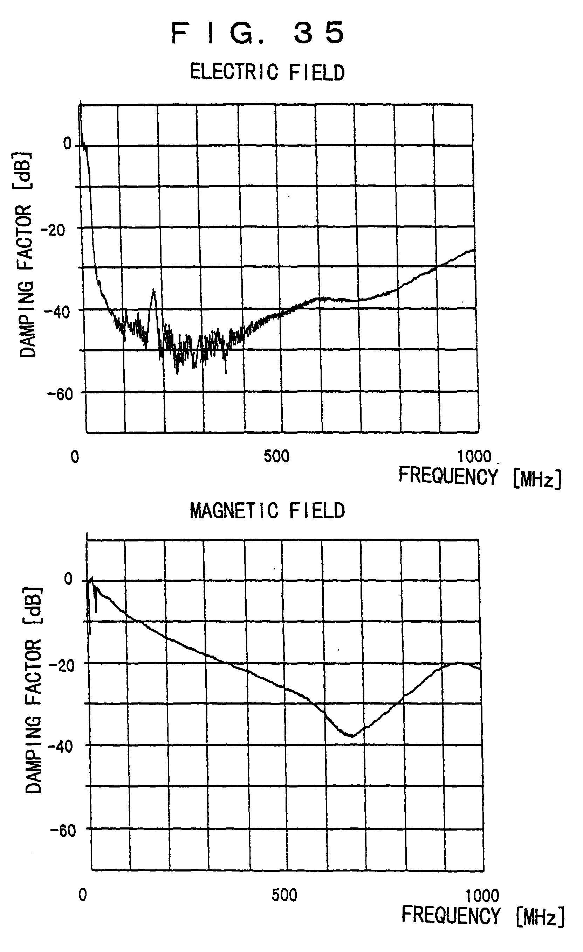

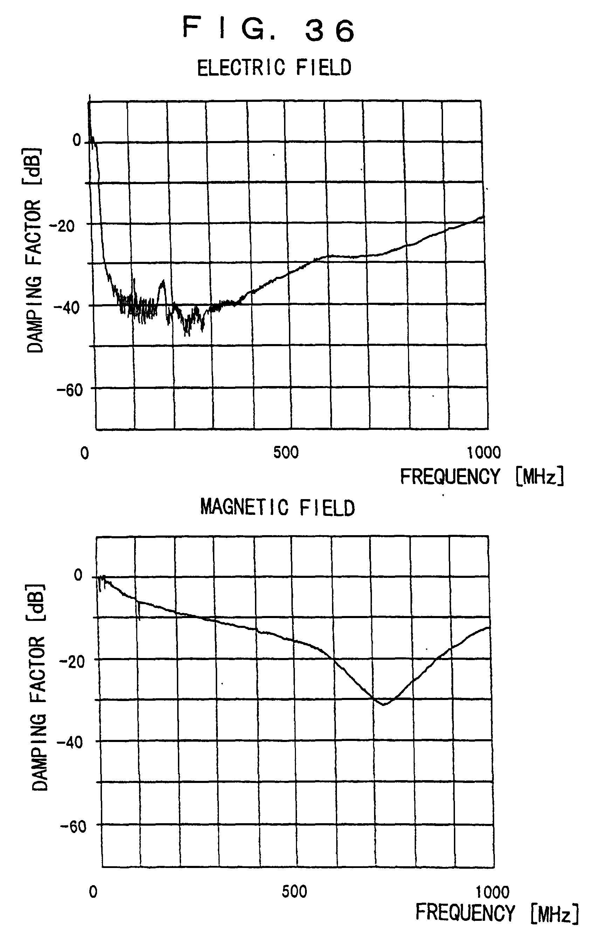

The electromagnetic wave-shielding sheet of the eighth embodiment of the present invention will be described hereafter with reference to FIGS. 21 to 36. FIG. 21 is a schematic descriptive view of the electromagnetic wave-shielding sheet of the eighth embodiment of the present invention, FIG. 22 is a descriptive view of the electromagnetic wave-shielding sheet of the eighth embodiment thereof, FIG. 23 is a graph of the electromagnetic wave-shielding property of the electromagnetic wave-shielding sheet of the eighth embodiment thereof, FIG. 24 is a composition table indicating each of the composition example Nos. 37 to 47, FIG. 25 is a graph of the electromagnetic wave-shielding property of the composition example No. 36, FIG. 26 is a graph of the electromagnetic wave-shielding property of the composition example No. 37, FIG. 27 is a graph of the electromagnetic wave-shielding property of the composition example No. 38, FIG. 28 is a graph of the electromagnetic wave-shielding property of the composition example No. 39, FIG. 29 is a graph of the electromagnetic wave-shielding property of the composition example No. 40, FIG. 30 is a graph of the electromagnetic wave-shielding property of the composition example No. 41, FIG. 31 is a graph of the electromagnetic wave-shielding property of the composition example No. 42, FIG. 32 is a graph of the electromagnetic wave-shielding property of the composition example No. 43, FIG. 33 is a graph of the electromagnetic wave-shielding property of the composition example No. 44, FIG. 34 is a graph of the electromagnetic wave-shielding property of the composition example No. 45, FIG. 35 is a graph of the electromagnetic wave-shielding property of the composition example No. 46, and FIG. 36 is a graph of the electromagnetic wave-shielding property of the composition example No. 47.

The electromagnetic wave-shielding sheet 1 of the eighth embodiment of the present invention is prepared by forming the electromagnetic wave-shielding material into a sheet-shape, which material has been obtained by adding a plural of kinds of the conductive agents (reinforcing agents) to the synthetic rubber or plastic material as the basic material so as to impart conductivity thereto, and adding a prescribed amount of sulfur to the synthetic rubber or plastic material.

The above-mentioned electromagnetic wave-shielding sheet 1 is formed into an almost square-shaped thin sheet body, which has a plurality of circular holes 2 formed thereon and passing therethrough so as to be spaced apart by a prescribed distance in the longitudinal and transverse directions of the sheet body. The first connecting portion 3 is formed on the adjacent two sides constituting the half of the periphery of the sheet so as to form steps in the longitudinal cross-section of the sheet body. The second connecting portion 4 is formed on the remaining two sides constituting the remaining half of the periphery of the sheet body so as to form inverse steps, which can be engaged with the portion corresponding to above-mentioned steps of the other sheet body. The sheet body has the front and back surfaces, which are different in color from each other.

The above-mentioned holes permit ventilation between the front and back surfaces of the sheet body. When the object to be shielded, such as an electronic instrument or the like is covered with the sheet body as the shield, it is possible to make heat diffusion from the inside of the sheet body, while ensuring a sufficient shielding property against the electromagnetic wave. As a result, any specific mechanism or device for diffusion of heat is not required and the formation of the holes causes the weight of the shielding sheet to be decreased, thus reducing the costs of the whole apparatus.

When the plurality of electromagnetic wave-shielding sheets 1 are arranged in rows, they are completely connected with each other by engaging the first connecting portion 3 with the second connecting portion 4 as shown in FIG. 21. It is therefore possible to make arrangement of the shielding sheets without forming a gap between two adjacent sheets, with the result that the maximum shielding property can be exhibited without deteriorating the shielding property at the connected portions and a uniform shielding effect can be obtained over the wide range by means of a plurality of electromagnetic wave-shielding sheets. Even when the arrangement direction of the electromagnetic wave-shielding material causes the shielding property to be changed, and in other words, the electromagnetic wave-shielding material has polarity, it is possible to make arrangement of the shielding sheets so as to maintain a proper polarity without making an improper arrangement thereof by connecting the first connecting portion of the shielding sheet with the second connecting portion of the other shielding sheet in an appropriate manner, thus maintaining a proper polarity of each of the sheet body and obtaining a uniform shielding effect. The above-mentioned first and second connecting portions 3 and 4 have the step-shape. They may however be formed into the other shape, for example, the combination of convex and concave portions having sharp edges or a round edge as shown in FIG. 22(B), or the combination of inclined surfaces as shown in FIG. 22(C).

In addition, the electromagnetic wave-shielding sheet 1 has the front and back surfaces, which are different in color from each other. Even when the shielding property at the front surface of the sheet body is slightly different from that at the back surface thereof, it is possible to make distinction between the front and back surfaces thereof, and the shielding sheets can be arranged under a proper condition, thus providing surely the prescribed shielding property. As is clear from FIG. 23, in which an impedance property of the above-mentioned electromagnetic wave-shielding material is also indicated, the impedance increases in the range of from 1 GHz to 3 GHz and the damping amount of the electromagnetic wave increases in accordance with the peak of the impedance. This reveals that the incident electromagnetic wave is absorbed, along with its loss, in the material having the high impedance, and in other words, the electromagnetic wave-shielding material serves as the absorbent of the electromagnetic wave.

Now, description will be given of the electromagnetic wave-shielding property of the electromagnetic wave-shielding sheet of the eighth embodiment of the present invention.

In the electromagnetic wave-shielding material for forming the electromagnetic wave-shielding sheet of the eighth embodiment, synthetic rubber is used as the basic material, and a plural kinds of conductive agents (reinforcing agents), compounding agents, and sulfur of 6 weight parts relative to 100 weight parts of the synthetic rubber are added to the synthetic rubber. There is used sulfur, which has been subjected to no surface treatment by means of oil or the like.

The conductive carbon and the carbon fiber are used as the conductive agent. The conductive carbon (the product name "Ketjen Black EC" manufactured by Lion Co. Ltd.) of 65 weight parts and the carbon fiber (having the fiber length of 6 mm) of 50 weight parts are added relative to 100 weight parts of the above-mentioned synthetic rubber.

With respect to the compounding agents to be added to the synthetic rubber as the basic material, zinc white No. 3 of 5 weight parts as the curing accelerator, stearic acid as the curing accelerator, softener and dispersant of 1 weight parts, special wax (the product name "Suntight S" manufactured by Seiko Chemical Co. Ltd.) as the age resistor of 2 weight parts, rapeseed oil of 10 weight parts and spindle oil of 10 weight parts as the softener, dibenzothiazyl·disulfide (hereinafter referred to as "DM") as the curing accelerator of 2 weight parts, diphenylguanidine (hereinafter referred to as "D") of 1 weight parts, tetramethylthiuram monosulfide (hereinafter referred to as "TS") of 0.3 weight parts and 2-mercaptobenzothiazole (hereinafter referred to as"M") of 0.5 weight parts are added relative to 100 weight parts of the synthetic rubber.

Sheets of the composition example Nos. 36 to 47 are formed with the use of the electromagnetic wave-shielding material having the above-mentioned blending composition. For each of the thus formed sheets, comparison was made in the electromagnetic wave-shielding property. Evaluation results will be described below on the basis of FIGS. 25 to 36. Each of the sheets had a thickness of 4 mm.

In the composition No. 36 as the comparison example, no holes are formed at all. Recognition was given that, according to the composition example No. 36, the damping factor was under -50 dB within the range of from 200 to 900 MHz in the electric field, and the damping factor was under -40 dB, which was a standard value in the damping effect, in almost the entire frequency band, and that the high electromagnetic wave-shielding effect could be obtained in the high frequency band of hundreds MHz.

In the composition example Nos. 37 to 41, the holes each having the diameter of 5 mm are arranged in the longitudinal and transverse directions of the sheet at regular intervals, so that the distance between the central points of the adjacent two holes is set as 33.3 mm in the example No. 37, 28.6 mm in the example No. 38, 25 mm in the example No. 39, 22.2 mm in the example No. 40 or 10.5 mm in the example No. 41. As shown in FIGS. 26 to 30, recognition was given that, the damping factor was under -40 dB, which was a standard value in the damping effect, within the range of from 100 to 800 MHz in the electric field in the composition Nos. 37 to 40, although the distance between the adjacent holes was so small as to increase the number of holes, and the electromagnetic wave-shielding property was deteriorated according as void was increased, and that a sufficient electromagnetic wave-shielding property could be ensured even when the holes were formed till the prescribed void was obtained.

In the composition example Nos. 42 to 45, the holes each having the diameter of 10 mm are arranged in the longitudinal and transverse directions of the sheet at regular intervals, so that the distance between the central points of the adjacent two holes is set as 33.3 mm in the example No. 42, 28.6 mm in the example No. 43, 25 mm in the example No. 44, or 22.2 mm in the example No. 45. Also in the composition example Nos. 42 to 45, the distance between the adjacent holes is so small as to increase the number of holes, and the electromagnetic wave-shielding property is deteriorated according as void is increased. A sufficient shielding property is not obtained especially in the composition example Nos. 43 to 45. In the composition example Nos. 42 to 45, the damping factor is deteriorated by the maximum value of 10 dB in the frequency band of at least about 400 MHz, in comparison with the above-mentioned composition example Nos. 37 to 40, in which the distance between the central points of the adjacent two holes is made constant. It is considered that increasing the diameter of the holes causes the above-mentioned deterioration. Recognition was given that, according to the composition example No. 42, there was obtained the electromagnetic wave-shielding property, which was more excellent than that of the composition example No. 40, except for a certain peak portion, and that a sufficient electromagnetic wave-shielding property could be ensured by maintaining the distance between the adjacent two holes of at least prescribed value, even when the void was large.

In the composition example Nos. 46 and 47, the holes each having the diameter of 12 mm are arranged in the longitudinal and transverse directions of the sheet at regular intervals, so that the distance between the central points of the adjacent two holes is set as 33.3 mm in the example No. 46 or 22.2 mm in the example No. 47. As shown in FIGS. 35 and 36, in the composition example Nos. 46 and 47, the electromagnetic wave-shielding property is deteriorated so that a sufficient shielding property cannot be obtained, according as the void becomes large. The damping factor is also further deteriorated in the high frequency band in comparison with the above-mentioned composition example Nos. 42 to 45, in which the distance between the central points of the adjacent two holes is made constant.

As described above, in the electromagnetic wave-shielding sheet, which is formed into a sheet body with the use of the electromagnetic wave-shielding material obtained by adding the blending constituents in prescribed amounts, the holes have a small influence on the damping effect against the electromagnetic wave in the frequency band of under 400 MHz and a prescribed shielding property can be ensured, so long as the void becomes remarkably large, even when a plurality of holes are formed at prescribed intervals. In the frequency band of at least 400 MHz, a sufficient shielding property can be obtained, provided that the holes have a diameter, which is equal to or smaller than the prescribed value and they are arranged at intervals, which are larger than the prescribed value.

In the electromagnetic wave-shielding sheet of the embodiments described above of the present invention, the holes have a circular shape. The shape of the holes is not limited only to a circle, and may be any other such as a square, a polygon or the like.

### [Ninth Embodiment]

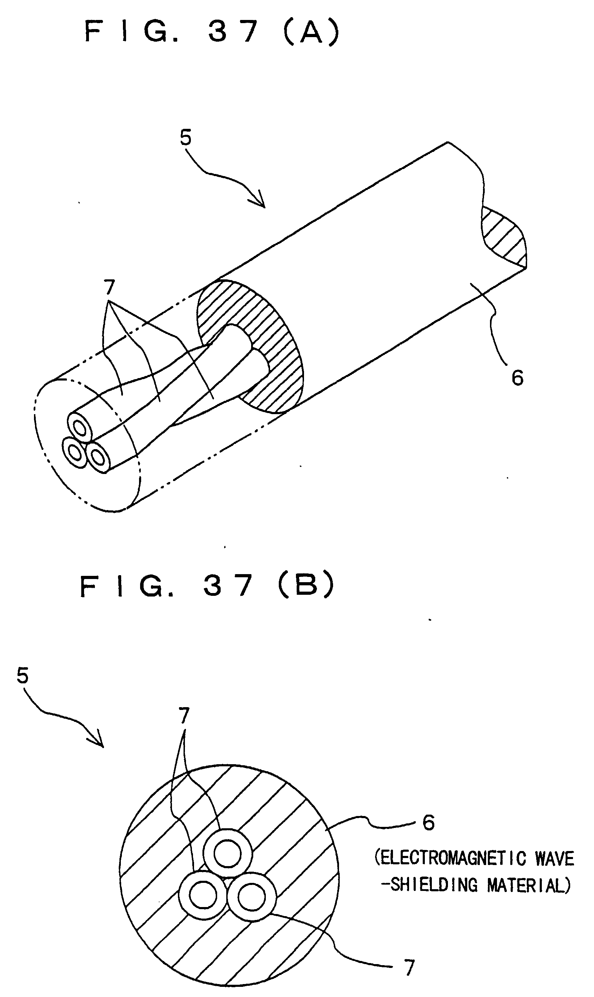

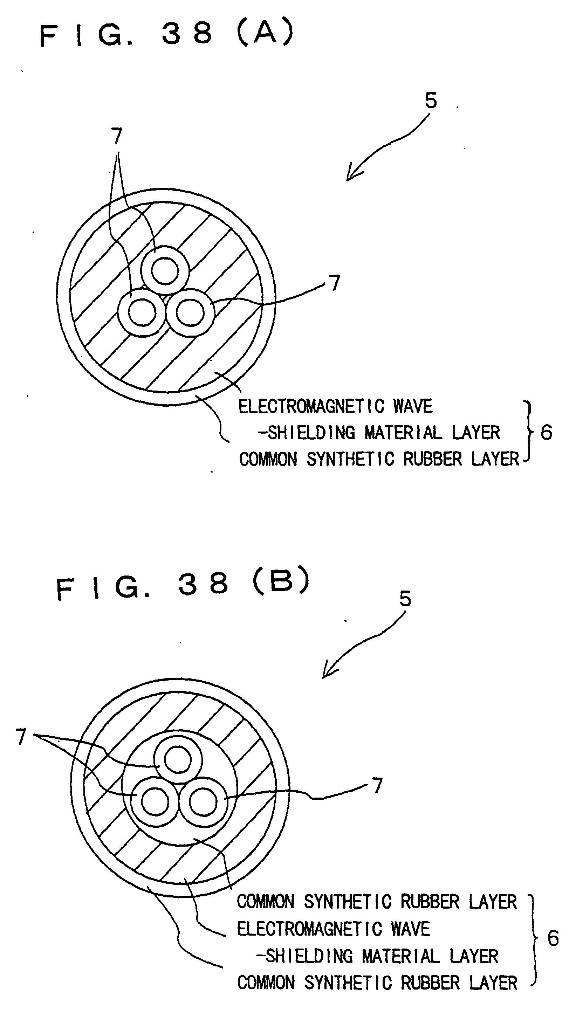

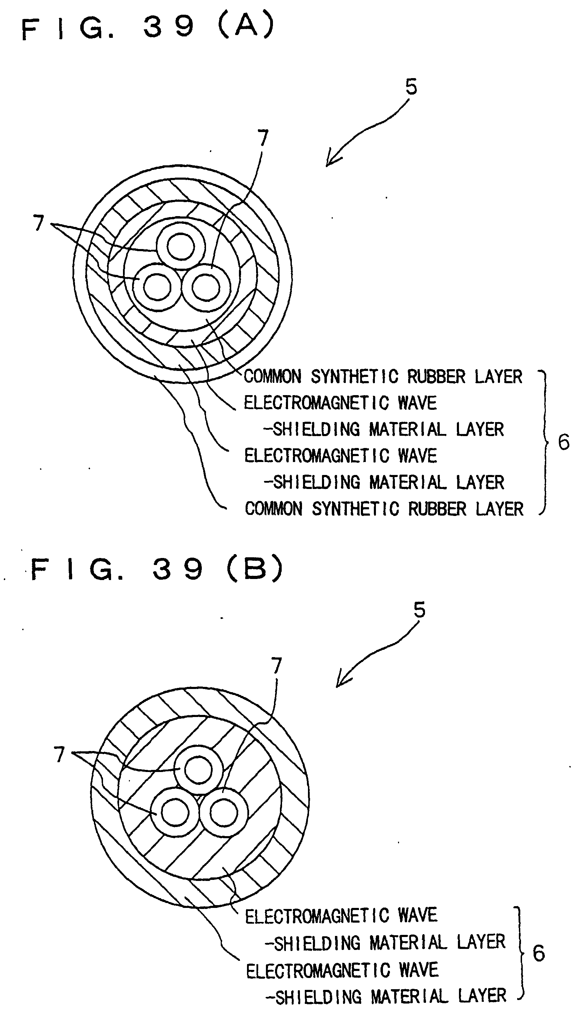

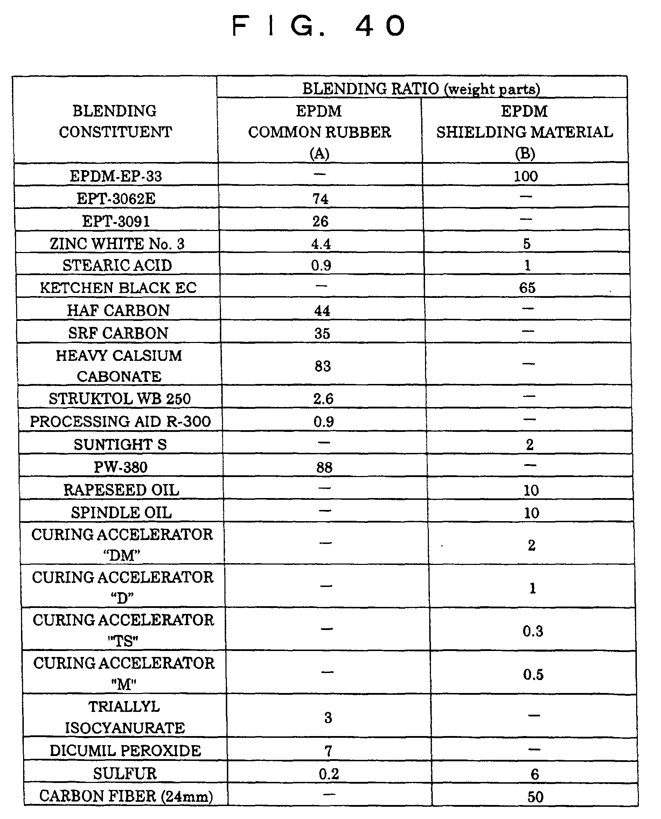

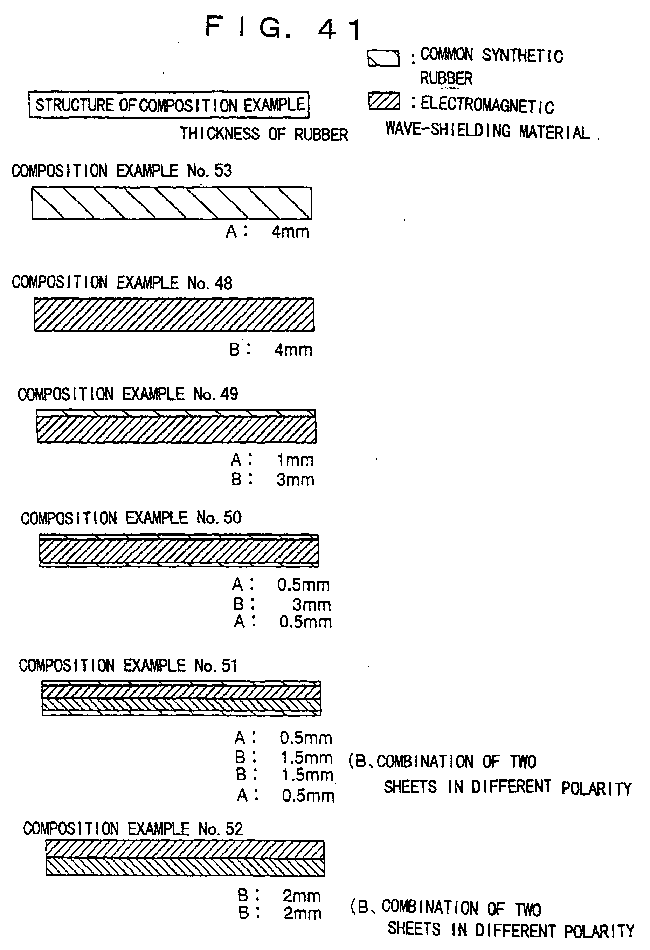

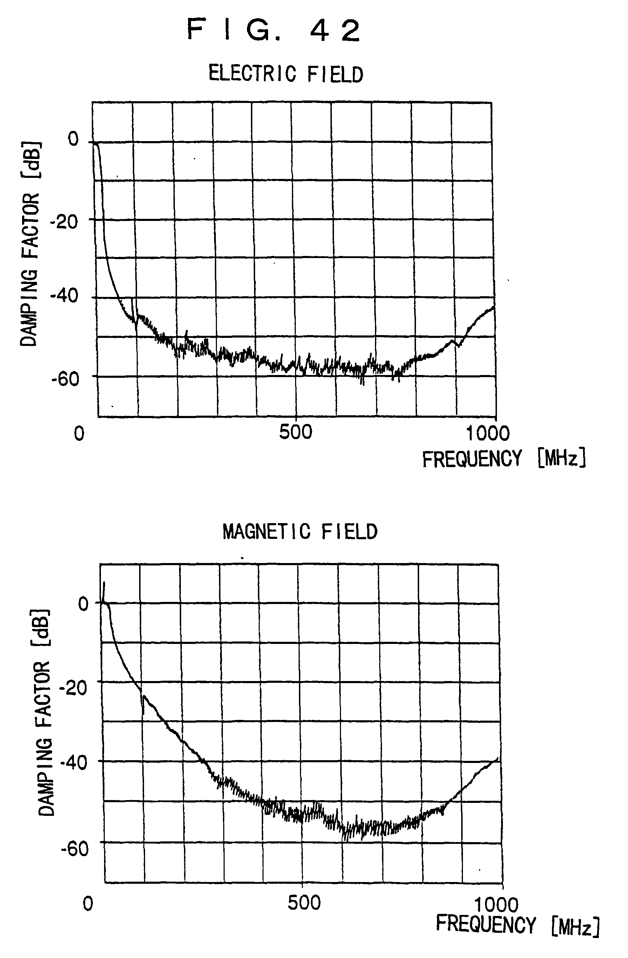

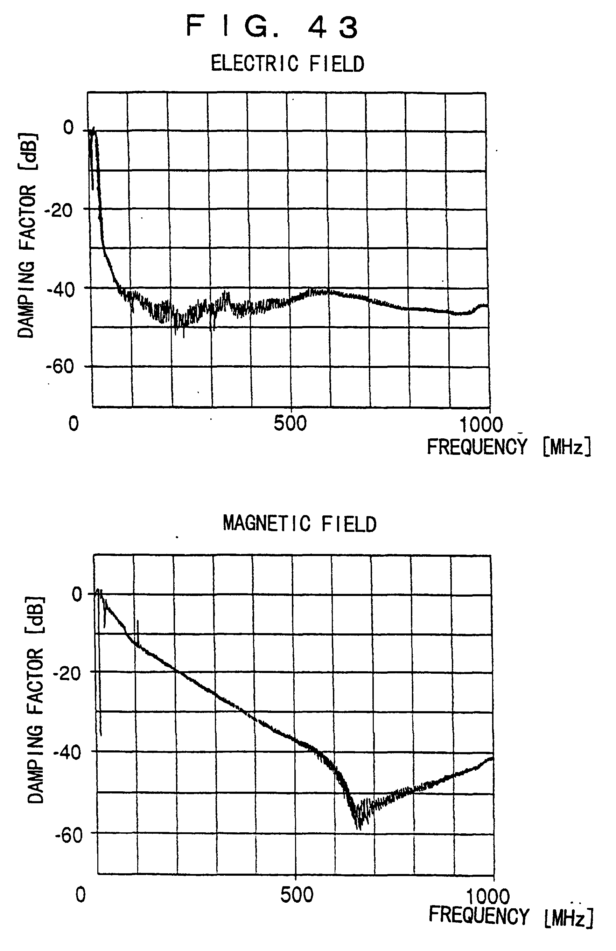

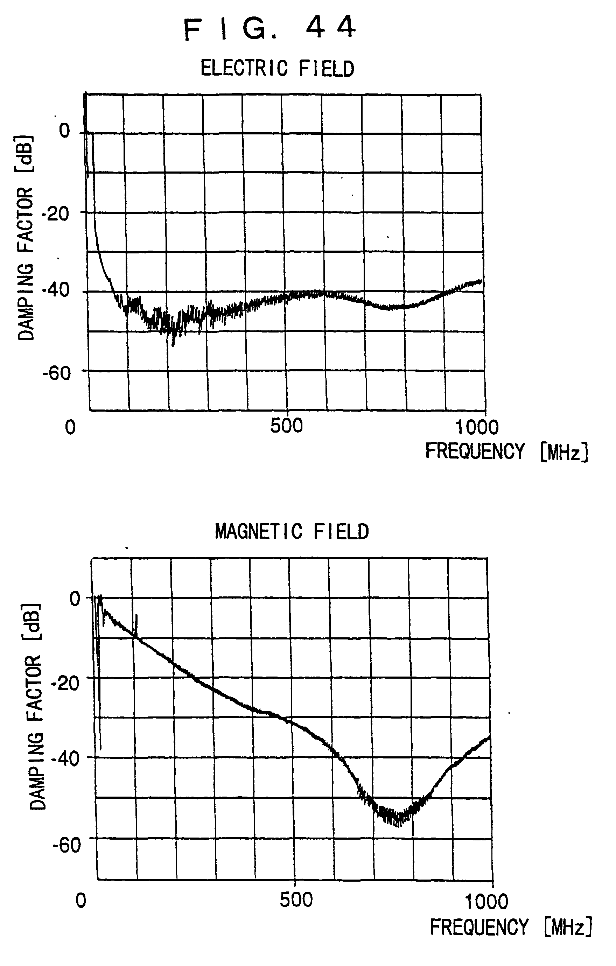

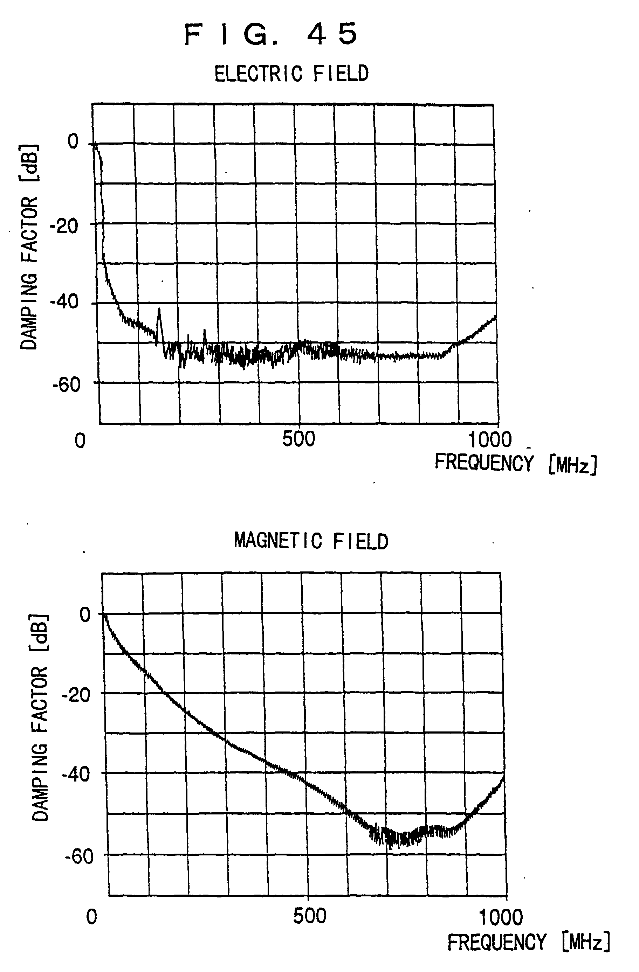

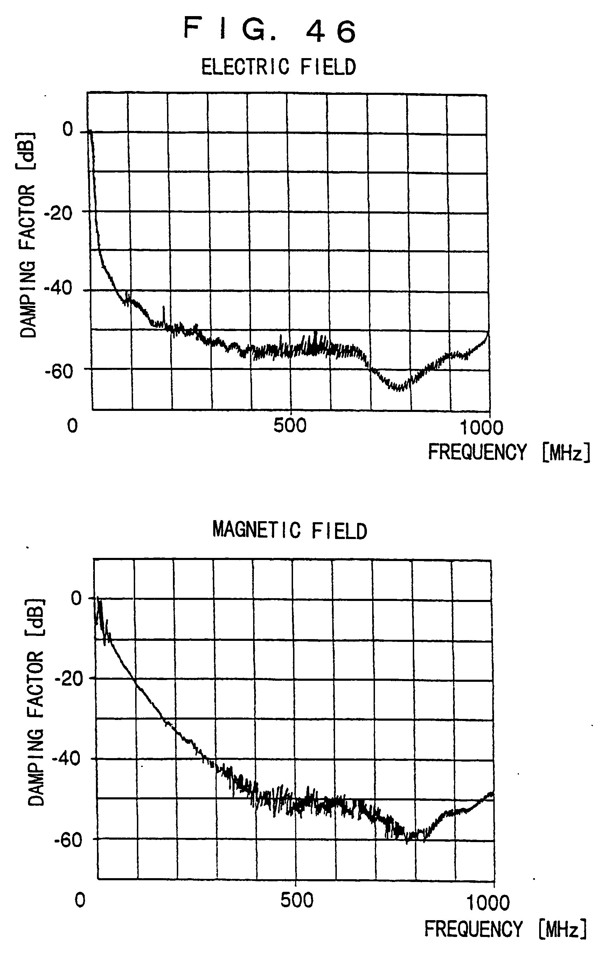

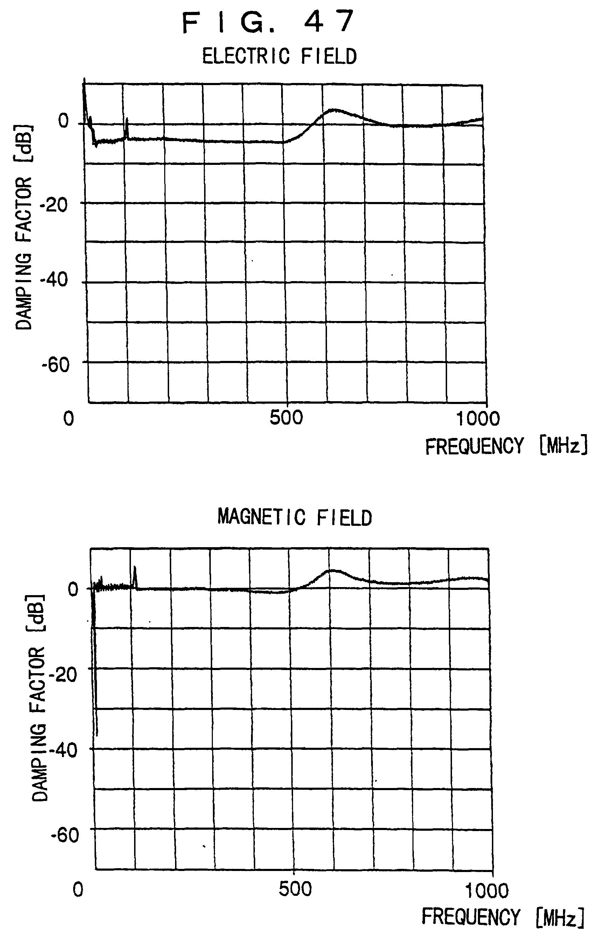

The cable of the ninth embodiment of the present invention will be described hereafter with reference to FIGS. 37 to 47. FIG. 37 is a schematic descriptive view of the composition example No. 48 of the cable of the ninth embodiment of the present invention, FIGS. 38(A) and 38(B) are cross-sectional views of the composition example Nos. 49 and 50 of the cable of the ninth embodiment of the present invention, respectively, FIGS. 39(A) and 38(B) are cross-sectional views of the composition example Nos. 51 and 52 of the cable of the ninth embodiment of the present invention, respectively, FIG. 40 is a blending table for the outer cover of the cable of the ninth embodiment of the present invention, FIG. 41 is a construction descriptive view of the outer cover of the composition example Nos. 48 to 53 of the cable of the ninth embodiment of the present invention, FIG. 42 is a graph of the electromagnetic wave-shielding property of the composition example No. 48 of the cable of the ninth embodiment of the present invention, FIG. 43 is a graph of the electromagnetic wave-shielding property of the composition example No. 49 of the cable of the ninth embodiment of the present invention, FIG. 44 is a graph of the electromagnetic wave-shielding property of the composition example No. 50 of the cable of the ninth embodiment of the present invention, FIG. 45 is a graph of the electromagnetic wave-shielding property of the composition example No. 51 of the cable of the ninth embodiment of the present invention, FIG. 46 is a graph of the electromagnetic wave-shielding property of the composition example No. 52 of the cable of the ninth embodiment of the present invention and FIG. 47 is a graph of the electromagnetic wave-shielding property of the composition example No. 53 of the cable of the ninth embodiment of the present invention.

The cable 5 of the ninth embodiment of the present invention is obtained by covering a core wire with the outer cover, a part or the entire of which is formed of the electromagnetic wave-shielding material, which had been obtained by adding a plural kinds of conductive agents (reinforcing agents) to rubber material as the basic material so as to impart conductivity to the rubber material, and adding a prescribed amount of sulfur to the rubber material. Conductive carbon and carbon fiber are used as the conductive agents (reinforcing agents). They are added in amounts, in which the kneading operation of them and the above-mentioned rubber material may easily be carried out and there is no problem in the manufacturing process. Softener, processing aid, age resistor, accelerator and the like are added to the rubber material as the basic material, in addition to zinc white as the curing assistant. A prescribed amount of fine short fiber or powder of a metallic compound such as ferrite or the like having an electromagnetic wave-absorbing property is added to the rubber material, as the occasion demands. The cables 5 of the composition example Nos. 48 to 52, in which the electromagnetic wave-shielding material having the blending composition mentioned above is used as the outer cover, are shown in FIGS. 37 to 39.

In the composition example No. 48 as shown in FIG. 37, the core wire 7 is covered alone with the electromagnetic wave-shielding material having the above-mentioned blending composition to prepare a cable 5. According to the composition example No. 48, it is possible to restrain the influence of the electromagnetic wave from the outside by means of the cable itself, which has the outer cover 6 formed of the electromagnetic wave-shielding material, and to absorb the electromagnetic wave generated by the cable itself so as to prevent the electromagnetic wave from being emitted toward the outside. As a result, it is possible to prevent the cable from being converted into the noise source and no extra space is required, unlike the provision of a filter and the like. The flexibility of the cable is not substantially deteriorated, unlike the metallic net and the metallic foil, thus leading to an excellent handling property.

In the composition example No. 49 as shown in FIG. 38(A), the cable 5 is provided with the outer cover 6 having the double layer structure, which comprises the inner layer formed of the electromagnetic wave-shielding material and the outer layer formed of a common rubber material having no conductivity. According to the composition example No. 49, the insulating property against the outside can be ensured by means of the outer layer formed of the common rubber material. As a result, there needs no consideration of the specific insulation of the cable, and the cable can safely be used alone in any place.

In the composition example No. 50 as shown in FIG. 38(B), the cable 5 is provided with the outer cover 6 having the triple layer structure, which comprises the innermost layer formed of the common rubber material having no conductivity, the intermediate layer formed of the electromagnetic wave-shielding material and the outermost layer formed of the common rubber material having no conductivity, so that the shielding material layer is held between the common rubber material layers. According to the composition example No. 50, the insulating property against the outside can be ensured by means of the outermost layer formed of the common rubber material. As a result, there needs no consideration of the specific insulation of the cable, and the cable can safely be used alone in any place, and the insulation between the electromagnetic wave-shielding material layer and the core wire 7 is ensured.

In the composition example No. 51 as shown in FIG. 39(A), the cable 5 is provided with the outer cover 6 having the quadruple layer structure, which composed of innermost and outermost layers formed of the common synthetic rubber material having no conductivity and dual intermediate layers having different polarities from each other, so that the dual electromagnetic wave-shielding material layers are held between the two common rubber material layers. According to the composition example No. 51, irregularity of the electromagnetic wave-shielding property due to the polarity can be solved so as to minimize the influence of the irregularity by providing the outer cover 6 having the quadruple layer structure, in which the dual intermediate layers held between the common rubber material layers are arranged so as to be different in polarity from each other. As a result, the electromagnetic wave-shielding property can securely be achieved, thus leading to an excellent damping effect against the electromagnetic wave.

In the composition example No. 52 as shown in FIG. 39(B), the cable 5 is provided with the outer cover 6 having the double layer structure, which consists of two layers formed of the electromagnetic wave-shielding material. The above-mentioned two layers are arranged as the inner and outer layers so as to be different in polarity from each other. According to the composition example No. 52, irregularity of the electromagnetic wave-shielding property due to the polarity can be solved in mutual compensation of these two layers. As a result, the electromagnetic wave-shielding property can securely be achieved in comparison with the outer cover 6 having the same thickness of the above-mentioned composition example No. 48, thus leading to an excellent damping effect against the electromagnetic wave.

In each of the composition examples of the cable 5, a plurality of insulated core wires is used. There may however be used a single insulated core wire or a single bare wire.

Then, there was made the comparison in the electromagnetic wave-shielding property while changing the structure of the outer cover, for each of the cables of the ninth embodiment of the present invention. The evaluation results thereof will be described on the basis of FIGS. 40 to 47.

In the electromagnetic wave-shielding material used as the outer cover material of the cable of the present invention, the synthetic rubber (the product name "EPDM-EP-33" manufactured by Japan Synthetic Rubber Co. Ltd.) is used as the basis material, and a plural kinds of conductive agents (reinforcing agents), blending agents and sulfur of 6 weight parts relative to 100 weight parts of the synthetic rubber are added to the synthetic rubber so as to impart the conductivity thereto. There is used sulfur, which has been subjected to no surface treatment by means of oil or the like. The oil furnace black (the product name "Ketjen Black EC" manufactured by Lion Co. Ltd.) is used as the conductive carbon, which is the above-mentioned conductive agent (the reinforcing agent). It is added in an amount of 65 weight parts relative to 100 weight parts of the above-mentioned synthetic rubber. The carbon fiber (, which has a fiber length of 24 mm) is added to the synthetic rubber in an amount of 50 weight parts relative to 100 weight parts of the synthetic rubber.

With respect to the compounding agents to be added to the synthetic rubber as the basic material, zinc white No. 3 of 5 weight parts as the curing accelerator, stearic acid as the curing accelerator, softener and dispersant of 1 weight parts, special wax (the product name "Suntight S" manufactured by Seiko Chemical Co. Ltd.) as the age resistor of 2 weight parts, rapeseed oil of 10 weight parts and spindle oil of 10 weight parts as the softener, dibenzothiazyl·disulfide (hereinafter referred to as "DM") as the curing accelerator of 2 weight parts, diphenylguanidine (hereinafter referred to as "D") of 1 weight parts, tetramethylthiuram monosulfide (hereinafter referred to as "TS") of 0.3 weight parts and 2-mercaptobenzothiazole (hereinafter referred to as"M") of 0.5 weight parts are added relative to 100 weight parts of the synthetic rubber.

In the common synthetic rubber having no conductivity, which is used as a part of the outer cover in combination with the electromagnetic wave-shielding material, the synthetic rubber (the product name "EPT-3062E" of 74 % and the product name "EPT-3091" of 26 %, both manufactured by Mitsui Petrochemical Industry Co. Ltd.) is used as the basic material, sulfur of 0.2 weight parts, and the HAF (high abrasion furnace) carbon of 44 weight parts, the SRF carbon of 35 weight parts and heavy calcium carbonate of 83 weight parts as fillers are added relative to 100 weight parts of the synthetic rubber, and in addition, the zinc white No. 3 of 4.4 weight parts and stearic acid of 0.9 weight parts as the blending agents, the product name "Struktol WB250" of 2.6 weight parts as the processing aid manufactured by Schill & Seilacher Co. Ltd., the product name "R-300" of 0.9 weight parts ass the processing aid manufactured by Kao Co. Ltd., the product name "PW-380" of 88 weight parts as the softener manufactured by Idemitsu Kosan Co. Ltd., triallyl isocyanurate of 3 weight parts as the curing agent and cross linking agent and dicumil peroxide of 7 weight parts are added.

The blending constituents and added amounts of each of the above-mentioned electromagnetic wave-shielding materials and common rubbers are shown in FIG. 40.

The outer cover based on each of the composition examples was formed with the use of the above-mentioned electromagnetic wave-shielding material and the common synthetic rubber having no conductivity (see FIG. 41). First, there was obtained as the above-mentioned composition example No. 48 a cable provided around its core wire with an outer cover, which had a single layer structure composed only of the electromagnetic wave-shielding material having the above-mentioned chemical composition. The outer cover had a thickness of 4 mm.

Then, there was obtained as the above-mentioned composition example No. 49 a cable provided around its core wire with an outer cover, which had a double layer structure composed of the electromagnetic wave-shielding material layer having the above-mentioned chemical composition and the common synthetic rubber having no conductivity. The outer cover had a thickness of 4 mm as in the above-mentioned composition example No. 48, and of these two layers, the electromagnetic wave-shielding material layer had a thickness of 3 mm and the common synthetic rubber layer had a thickness of 1 mm.

There was obtained as the above-mentioned composition example No. 50 a cable provided with an outer cover, which had a triple layer structure composed of innermost and outermost layers both formed of the common synthetic rubber having no conductivity and an electromagnetic wave-shielding material layer held between the innermost and outermost layers. The outer cover had a thickness of 4 mm as in the above-mentioned composition example No. 48, and of these three layers, the intermediate electromagnetic wave-shielding material layer had a thickness of 3 mm and each of the innermost and outermost layers had a thickness of 0.5 mm.

There was obtained as the above-mentioned composition example No. 51 a cable provided with an outer cover, which had a quadruple layer structure, which composed of the innermost and outermost layers formed of the common synthetic rubber material having no conductivity and dual electromagnetic wave-shielding material layers, which had been formed by applying different injection angles in an extrusion process or different spiral directions in an spiral extrusion process so as to maintain the deviation in polarity due to the addition of the additives by an angle of about 90 degrees. The outer cover had a thickness of 4 mm as in the above-mentioned composition example No. 48, and of these four layers, each of the intermediate electromagnetic wave-shielding layers had a thickness of 1.5 mm and each of the innermost and outermost layers had a thickness of 0.5 mm.

There was obtained as the above-mentioned composition example No. 52 a cable provided around its core wire with an outer cover, which had a double layer structure composed of two electromagnetic wave-shielding material layers, which had been formed by taking the same way as in the above-mentioned composition example No. 51 so as to maintain the deviation in polarity by an angle of about 90 degrees. The outer cover had a thickness of 4 mm as in the above-mentioned composition example No. 48, and each of the electromagnetic wave-shielding material layers had a thickness of 2 mm.

Further, there was obtained for the comparison purpose as the composition example No. 53 a cable provided with an outer cover, which had a single layer structure composed only of the common synthetic rubber layer having no conductivity. The outer cover had a thickness of 4 mm as in the above-mentioned composition example No. 48.

Each of the cables of the composition examples was arranged in circumstances, in which the electromagnetic wave was generated, to subject to a test for the electromagnetic wave-shielding property. Degree of the electromagnetic wave-shielding effect of each of these cables may be expressed by the damping factor, which is the ratio of an incident electric field (magnetic field) from the front surface of the cable to an electric field (magnetic field) after penetration of the cable. Here, there was investigated the damping property against the electromagnetic wave in the frequency range of from 0 to 1,000 MHz. The thus obtained property is expressed by a graph (see FIGS. 42 to 47), in which an abscissa represents the frequency (MHz) of the electromagnetic wave and an ordinate represents the damping factor (dB).

With respect to the electromagnetic wave-shielding property of each of the composition examples, recognition was given that, according to the composition example No. 48, the damping factor was under -50 dB in the frequency band of from 400 to 800 MHz as shown in FIGS. 42 TO 47, in comparison with the composition example No. 53, in which almost no damping effect in both of the electric and magnetic fields was obtained, and there was obtained a wide range of frequency, in which the damping factor was under -40 dB, which was a standard value in the damping effect, and that the high electromagnetic wave-shielding effect could be obtained in the high frequency band of hundreds MHz.

Confirmation was given that, there was almost no difference in the damping property in both of the electric field and the magnetic field between the composition Nos. 49 and 50, in which the electromagnetic wave-shielding material and the common rubber are combined together, and that the damping effect was slightly reduced in comparison with the above-mentioned composition example No. 48, and accordingly, the position of the common rubber layer had small influence on the electromagnetic wave-shielding property and that property was affected by the thickness of the electromagnetic wave-shielding material layer.

In addition, recognition was given that, according to the composition example No. 51 having the double layer structure, in which the intermediate electromagnetic wave-shielding material layers were different in polarity from each other, the high damping effect was obtained in comparison with the composition example No. 50 having the same position and thickness of the electromagnetic wave-shielding material layers as those of the composition example No. 51, and that the two electromagnetic wave-shielding material layers having the different polarity from each other improved the irregularity of the electromagnetic wave-shielding effect due to the polarity, thus providing an uniform electromagnetic wave-shielding effect.

Further, recognition was given that, according to the composition example No. 52 having the double layer structure, in which the electromagnetic wave-shielding material layers were different in polarity from each other, the damping effect was improved in the frequency band of at least 700 MHz in comparison with the composition example No. 48 having the same thickness of the electromagnetic wave-shielding material layer as that of the composition example No. 52, and that the two electromagnetic wave-shielding material layers having the different polarity from each other also improved the irregularity of the electromagnetic wave-shielding effect, thus providing an uniform electromagnetic wave-shielding effect. It was recognized that the damping effect was totally improved in comparison with the composition example No. 51 having the two electromagnetic wave-shielding layers, which were different in polarity from each other as in the composition example No. 52, and as a result, the electromagnetic wave-shielding effect was remarkably improved according as the thickness of the electromagnetic wave-shielding layer increased.

Recognition was give from the above-mentioned facts, that the outer cover for the cable, having a prescribed electromagnetic wave-shielding effect could be formed only with the use of the electromagnetic wave-shielding material obtained by blending the materials in a prescribed blending ratio, or with the use of the combination of the electromagnetic wave-shielding material with the common rubber.

### [Tenth Embodiment]

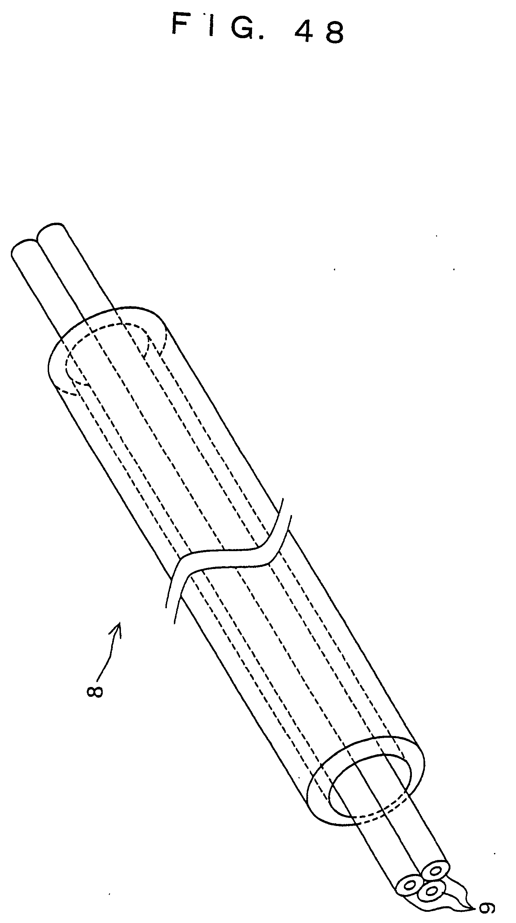

The cable cover of the tenth embodiment of the present invention will be described hereafter with reference to FIG. 48. FIG. 48 is a schematic descriptive view of the cable cover of the tenth embodiment of the present invention.

The cable cover 8 of this embodiment is formed into a tubular body with the use of the same electromagnetic wave-shielding material as in the ninth embodiment described above, which is obtained by adding sulfur, conductive carbon, carbon fiber, zinc white, softener, age resistor, curing assistant and the like to rubber material in the prescribed respective amounts. An electric wire 9 to be shielded from the electromagnetic wave is received in the inside of the cable cover 8.

According to the cable cover 8 of the tenth embodiment of the present invention, the influence of the electromagnetic wave from the outside of the cable cover can be minimized by means of the tubular body formed mainly of the rubber material, which has the electromagnetic wave-shielding property. It is also possible to prevent the cable from being converted into the noise source and no extra space is required, unlike the provision of a filter and the like. A plurality of electric wires or cables can be shielded as a whole, thus providing an excellent handling property.

In the cable cover of the above-mentioned tenth embodiment of the present invention, the electric wire 9 is received in the inside of the cable cover so as to block off the electromagnetic wave radiated from the electric wire 9 toward the outside or the electromagnetic wave radiated from the outside toward the electric wire 9. A tube or the like formed of insulating material such as rubber, plastic or the like may be arranged in the cable cover so as to pass therethrough. In this case, static electricity on the surface of the tube can be discharged outside through the electromagnetic wave-shielding material of the cable cover having the conductivity. It is therefore possible to prevent an electrical charge from being taken by bringing the surface of the tube into a frictional contact with the other insulating material so as to generate a spark due to the static electricity. As a result, there can be ensured safety against a combustible atmosphere or a combustible material passing through the tube.

Incidentally, in the electromagnetic wave-shielding sheet, cable or cable cover of the above-mentioned eighth to tenth embodiments of the present invention, the electromagnetic wave-shielding material includes the rubber material as the basic material. It may however include the plastic material as the basic material.

### Industrial Applicability

The electromagnetic wave-shielding material of the present invention described above can be used as a shield of an instrument, in which the electromagnetic interference (EMI) easily occurs, such as an electronic instrument, which is able to operate through ringing micro current, so as to minimize the influence of the electromagnetic wave from the outside. In addition, it is possible to absorb the electromagnetic wave generated from the instrument itself as shielded to restrain the electromagnetic wave from being propagated outside and to prevent the instrument being converted into the noise source. The electromagnetic wave-shielding material can easily be used in low cost in a place or a large-scaled object to be shielded, in which sound insulation property, impact absorption property and vibration controlling property are required.

The electromagnetic wave-shielding sheet of the present invention can be used in the form of a single shield or a plurality of shields, which are arranged without forming a gap therebetween so as to maintain a prescribed polarity relationship, to cover the object to be shielded such as the electrical instrument. It is possible to diffuse heat in the inside of the sheet through a plurality of holes formed thereon, while providing the electromagnetic wave-shielding effect. As a result, any specific mechanism or device for diffusion of heat is not required.

The electric wire or cable of the present invention can be used for minimizing the influence of the electromagnetic wave from the outside on the electric wire or cable and preventing the diffusion of the electromagnetic wave from the electric wire or cable itself. Such an electric wire or cable can safely be used and easily be obtained in low cost.

The cable cover of the present invention can be used for an electric wire or cable, which is required to avoid the influence of the electromagnetic wave from the outside, or for another electric wire or cable generating the electromagnetic wave having an adverse influence on the circumstances. Such an electric wire or cable can be covered with the cable cover so as to block off the electromagnetic wave.

## Claims

1. An electromagnetic wave-shielding material, wherein:
conductive filler is added to a rubber material so as to impart conductivity to said rubber material, and sulfur is added to said rubber material having the conductivity in an amount of from 4 to 16 weight parts relative to 100 weight parts of said rubber material.

2. An electromagnetic wave-shielding material as claimed in Claim 1, wherein:
said conductive filler comprises conductive carbon.

3. An electromagnetic wave-shielding material as claimed in Claim 1 or 2, wherein:
zinc white is added to said rubber material.

4. An electromagnetic wave-shielding material as claimed in Claim 1, wherein:
conductive carbon of from 35 to 65 weight parts and zinc white of from 3 to 30 weight parts both relative to 100 weight parts of said rubber material are added to said rubber material so as to impart the conductivity to the same.

5. An electromagnetic wave-shielding material as claimed in any one of Claims 1 o 4, wherein:
a net member formed of metal is held between members made of said rubber material or said rubber material, to which any one of the additives is added.

6. An electromagnetic wave-shielding material as claimed in any one of Claims 1 to 5, wherein:
metallic short fiber is added to said rubber material in an amount of from 20 to 40 weight parts relative to 100 weight parts of said rubber material.

7. An electromagnetic wave-shielding material as claimed in any one of Claims 1 to 6, wherein:
carbon fiber is added to said rubber material in an amount of from 10 to 50 weight parts relative to 100 weight parts of said rubber material so as to impart the conductivity to the same.

8. An electromagnetic wave-shielding material, wherein:
conductive carbon is added to plastic material in an amount of from 35 to 65 weight parts relative to 100 weight parts of said plastic material, and carbon fiber is added to said plastic material in an amount of from 10 to 40 weight parts relative to 100 weight parts of said plastic material.

9. An electromagnetic wave-shielding material as claimed in Claim 8, wherein:
sulfur is added to said plastic material in an amount of from 4 to 16 weight parts relative to 100 weight parts of said plastic material.

10. An electromagnetic wave-shielding material as claimed in Claim 8 or 9, wherein:
zinc white is added to said plastic material in an amount of from 3 to 30 weight parts relative to 100 weight parts of said plastic material.

11. An electromagnetic wave-shielding sheet, wherein:
said electromagnetic wave-shielding material as claimed in any one of Claims 1 to 10 is formed into a sheet body having a prescribed shape, and said sheet body has a plurality of holes formed thereon so as to be spaced apart by a prescribed distance from each other, which pass through said sheet body and has a prescribed shape.

12. An electromagnetic wave-shielding sheet as claimed in Claim 11, wherein:
said sheet body is formed into a rectangular shape, in which a first connecting portion having a prescribed shape is formed so as to extend peripherally over adjacent two sides of a periphery thereof, and a second connecting portion having a prescribed shape is formed so as to extend peripherally over remaining adjacent two sides of said periphery, said second connecting portion being connectable integrally with a first connecting portion of another sheet body having the same structure as said sheet body.

13. An electromagnetic wave-shielding sheet as claimed in Claim 11 or 12, wherein:
said sheet body has front and back surfaces, which are different in color from each other.

14. An electric wire or cable, wherein:
at least one core wire is covered integrally with said electromagnetic wave-shielding material as claimed in any one of Claims 1 to 10 by means of an extrusion method.

15. An electric wire or cable as claimed in Claim 14, wherein:
fine short fiber or powder of a metallic compound having an electromagnetic wave-absorbing property is added to said rubber material or said plastic material composing said electromagnetic wave-shielding material in an amount of from 50 to 230 weight parts relative to 100 weight parts of said rubber material or said plastic material.

16. An electric wire or cable as claimed in Claim 14 or 15, wherein:
said core wire is covered with said electromagnetic wave-shielding material and an other rubber or plastic material having no conductivity so that said core wire is coated with layers of said electromagnetic wave-shielding material and said other rubber or plastic material.

17. An electric wire or cable as claimed in Claim 16, wherein:
said electromagnetic wave-shielding material covers said core wire so that said electromagnetic wave-shielding material is held between two layers of said other rubber or plastic material.

18. An electric wire or cable as claimed in any one of Claims 14 to 17, wherein:
said core wire is covered with a plurality of laminated layers of said electromagnetic wave-shielding material, which are different in polarity from each other.

19. A cable cover, wherein:
said electromagnetic wave-shielding material as claimed in any one of Claims 1 to 10 is formed into a tubular shape, with which at least one electric wire or cable is surrounded.

20. A cable cover as claimed in Claim 19, wherein:
said electromagnetic wave-shielding material is laminated with at least one layer of rubber or plastic material having no conductivity so as to form a tubular shape.
